(19) Europäisches Patentamt
European Patent Office
Office européen des brevets

(11) **EP 2 117 840 B1**

## (12) EUROPÄISCHE PATENTSCHRIFT

(45) Veröffentlichungstag und Bekanntmachung des Hinweises auf die Patenterteilung:
**04.01.2017 Patentblatt 2017/01**

(21) Anmeldenummer: **08707587.5**

(22) Anmeldetag: **07.02.2008**

(51) Int Cl.:
**B32B 29/00** *(2006.01)*  **D21H 21/44** *(2006.01)*

(86) Internationale Anmeldenummer:
**PCT/EP2008/000926**

(87) Internationale Veröffentlichungsnummer:
**WO 2008/095698 (14.08.2008 Gazette 2008/33)**

(54) **SICHERHEITSELEMENT FÜR EIN SICHERHEITSDOKUMENT UND VERFAHREN ZU SEINER HERSTELLUNG**

SECURITY ELEMENT FOR A SECURITY DOCUMENT AND METHOD FOR PRODUCTION THEREOF

ÉLÉMENT DE SÉCURITÉ POUR UN DOCUMENT PROTÉGÉ ET PROCÉDÉ DE FABRICATION DE L'ÉLÉMENT DE SÉCURITÉ

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **07.02.2007 DE 102007005884**
**23.08.2007 DE 102007039996**

(43) Veröffentlichungstag der Anmeldung:
**18.11.2009 Patentblatt 2009/47**

(73) Patentinhaber: **Leonhard Kurz Stiftung & Co. KG**
**90763 Fürth (DE)**

(72) Erfinder:
• **ATTNER, Juri**
**90559 Burgthann (DE)**

• **STAUB, René**
**CH-6332 Hagendorn (CH)**
• **WEBER, Klaus**
**90513 Zirndorf (DE)**

(74) Vertreter: **Zinsinger, Norbert**
**Louis, Pöhlau, Lohrentz**
**Patentanwälte**
**Postfach 30 55**
**90014 Nürnberg (DE)**

(56) Entgegenhaltungen:
**WO-A-97/19820**  **DE-A1- 10 226 114**
**DE-A1-102004 042 136**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

Printed by Jouve, 75001 PARIS (FR)

**Beschreibung**

Die Erfindung betrifft ein Sicherheitselement mit mindestens einer, zumindest bereichsweise transparenten Strukturschicht, mit einer zumindest bereichsweise angeordneten diffraktiven ersten Reliefstruktur und einer zumindest bereichsweise angeordneten diffraktiven zweiten Reliefstruktur, wobei die erste und die zweite Reliefstruktur sich zumindest bereichsweise unterscheiden und parallel zur Ebene der Strukturschicht gesehen in unterschiedlichen Ebenen des Sicherheitselements angeordnet sind, wobei die erste Reliefstruktur an eine erste Reflektionsschicht mit einem ersten Umriss angrenzt und die zweite Reliefstruktur an eine zweite Reflektionsschicht mit einem zweiten Umriss angrenzt. Die Erfindung betrifft weiterhin unterschiedliche Verfahren zur Herstellung eines solchen Sicherheitselements und ein Sicherheitsdokument mit einem derartigen Sicherheitselement.

Sicherheitselemente mit einem derartigen Aufbau sind aus DE 10 2005 017 169 A1 bekannt. Diese werden hier mittels einer Transferfolie auf ein Sicherheitsdokument aufgebracht. Dabei ist eine dünne, nicht-selbsttragende Strukturschicht mit einer Schichtdicke < 10 µm vorhanden. Die erste Reliefstruktur ist nach der Applikation des Sicherheitselements auf ein Sicherheitsdokument an der Oberfläche des Sicherheitsdokuments angeordnet und kann eine optische und/oder technische Funktion aufweisen oder auch taktil erfasst werden. Eine Betrachtung des Sicherheitselements auf dem Sicherheitsdokument kann von lediglich einer oder alternativ von beiden Seiten erfolgen.

Die WO 97/19820 A1 beschreibt ein Sicherheitselement in Form eines Informationsträgers mit einer selbsttragenden Strukturschicht in einer Schichtdicke von > 20 µm, das auf ein Sicherheitsdokument, beispielsweise einen Scheck, aufgebracht wird. Eine Betrachtung des Sicherheitselements ist lediglich auf seiner, dem Sicherheitsdokument abgewandten Seite vorgesehen.

Die DE 102 26 114 A1 offenbart ein Sicherheitselement, welches sich aus zwei unterschiedlichen Sicherheitsmerkmalen zusammensetzt. Das erste Sicherheitsmerkmal weist zwei Kunststoffschichten auf, zwischen welchen eine Reliefstruktur abgeformt und eine Metallschicht angeordnet ist. Das andere Sicherheitsmerkmal besteht ebenfalls aus zwei Kunststoffschichten, zwischen welchen eine Beugungsstruktur abgeformt sowie eine Metallschicht angeordnet ist. Weiter ist eine opake Mittelschicht zwischen den Kunststoffschichten vorgesehen, wenn in den Metallschichten Unterbrechungen vorgesehen sind.

Bei den bekannten Sicherheitselementen sind, zumindest von einer Seite des Sicherheitselements gesehen, die erste Reflektionsschicht und gleichzeitig zumindest Bereiche der zweiten Reflektionsschicht sichtbar, wobei optische Effekte der ersten Reliefstruktur und der zweiten Reliefstruktur in Kombination sichtbar sind.

Es ist nun Aufgabe der Erfindung, die Fälschungssicherheit eines Sicherheitselements und eines damit versehenen Sicherheitsdokuments weiter zu erhöhen sowie ein Verfahren zur Bildung eines derartigen Sicherheitselements anzugeben.

Die Aufgabe wird für das Sicherheitselement mit mindestens einer, zumindest bereichsweise transparenten Strukturschicht, mit einer zumindest bereichsweise angeordneten diffraktiven ersten Reliefstruktur und einer zumindest bereichsweise angeordneten diffraktiven zweiten Reliefstruktur, wobei die erste und die zweite Reliefstruktur sich zumindest bereichsweise unterscheiden und parallel zur Ebene der Strukturschicht gesehen in unterschiedlichen Ebenen des Sicherheitselements angeordnet sind, wobei die erste Reliefstruktur an eine erste Reflektionsschicht mit einem ersten Umriss angrenzt und die zweite Reliefstruktur an eine zweite Reflektionsschicht mit einem zweiten Umriss angrenzt, gelöst, indem die erste Reflektionsschicht und die zweite Reflektionsschicht senkrecht zur Ebene der Strukturschicht gesehen bereichsweise ausgebildet sind und zumindest bereichsweise überlappen, wobei zumindest Teilbereiche des ersten und zweiten Umrisses senkrecht zur Ebene der Strukturschicht gesehen deckungsgleich zueinander und angrenzend an mindestens einen transparenten Bereich der Strukturschicht verlaufen, und der mittlere Abstand der zweiten Reflektionsschicht weniger als 15 µm beträgt und wobei - sofern die erste Reflektionsschicht einem Betrachter zugewandt ist - eine durch die zweite Reliefstruktur im Bereich der Überlappung generierte zweite Information zumindest teilweise verdeckt ist und dass - sofern die zweite Reflektionsschicht dem Betrachter zugewandt ist - eine von der ersten Reliefstruktur im Bereich der Überlappung generierte erste Information zumindest teilweise verdeckt ist.

Das gebildete Sicherheitselement ist schwer nachahmbar und gleichzeitig optisch besonders ansprechend und einprägsam, so dass es außerordentlich fälschungssicher ist. Das Sicherheitselement ist bereichsweise transparent ausgebildet. Insbesondere erscheint es einem Betrachter überwiegend transparent, wobei die transparenten Bereiche vorzugsweise mehr als 50% der Fläche des Sicherheitselements ausmachen. Es eignet sich daher besonders als Fensterelement oder auch als Sicherheitsfaden für Sicherheitsdokumente.

Es hat sich bewährt, wenn die erste und die zweite Information sich zumindest bereichsweise voneinander unterscheiden. So lässt sich ein 3-D-Effekt am Sicherheitselement erzielen.

Ein mittlerer Abstand zwischen der ersten und zweiten Reflektionsschicht beträgt weniger als 15 µm.

Vorzugsweise ist die erste Reflektionsschicht opak ausgebildet und verdeckt dem Betrachter zugewandt die zweite Information und gegebenenfalls weitere von der zweiten Reliefstruktur generierte Informationen zumindest bereichsweise. Alternativ ist die erste Reflektionsschicht transparent ausgebildet und mindestens eine erste opake Hilfsschicht verdeckt die zweite Information, gegebenenfalls auch weitere von der zweiten Reliefstruktur generierte Informationen, zumindest bereichsweise. Vorzugsweise ist auch die zweite Reflektionsschicht opak ausgebildet und verdeckt dem Betrachter zugewandt die erste Information und gegebenenfalls weitere von der ersten Reliefstruktur generierte Informationen zumindest bereichsweise. Alternativ ist die zweite Reflektionsschicht transparent ausgebildet und mindestens eine zweite opake Hilfsschicht verdeckt die erste Information, gegebenenfalls auch weitere von der ersten Reliefstruktur generierte Informationen, zumindest bereichsweise.

Dabei können die erste und die zweite Hilfsschicht auch durch eine einzige Schicht ausgebildet sein, die beiden Reflektionsschichten zugeordnet werden kann. Beispielsweise kann ein opaker Bereich der Strukturschicht eine einzige Hilfsschicht bilden, die sowohl der bereichsweise ausgebildeten ersten als auch der bereichsweise ausgebildeten zweiten Reflektionsschicht überlagert ist.

Dabei wird eine opake Reflektionsschicht vorzugsweise im Auflicht und im Durchlicht gesehen opak ausgebildet. Es ist aber genauso möglich, dass Reflektionsschichten lediglich im Auflicht gesehen bzw. in Reflektion für ein menschliches Auge opak erscheinen. Eine solche Reflektionsschicht kann im Durchlicht gesehen lokal sichtbar unterschiedliche Transmission aufweisen, so dass also durch Bereiche der Reflektionsschicht im Durchlicht gesehen erkennbar mehr sichtbares Licht dringt als durch andere Bereiche dieser Reflektionsschicht. Dies wird vorzugsweise durch unterschiedliche Schichtdickenbereiche oder kleinste Öffnungen in der/den Reflektionsschicht(en) erzielt.

Hierbei wird vom menschlichen Betrachter ein Bereich einer Reflektionsschicht im Durchlicht als opak empfunden, wenn die Transmission für sichtbares Licht kleiner als 5 %, insbesondere kleiner als 1 % beträgt. Als transluzent empfindet ein Betrachter im Durchlicht Bereiche mit einer Transmission für sichtbares Licht von größer als 10 %, insbesondere von größer als 20 %. Im Auflicht kann sich für einen Betrachter dabei in den, im Durchlicht transluzent wahrgenommenen Bereichen, der Eindruck eines opaken Schichtbereichs ergeben. Wird beispielsweise eine metallische Reflektionsschicht eingesetzt, so reflektieren die im Durchlicht opak und transluzent empfundenen Bereiche im Auflicht betrachtet maximal um einen Faktor 0,2 unterschiedlich. Eine um den Faktor 2 unterschiedliche Transmission ist für das menschliche Auge gut erkennbar, während ein Unterschied in der Reflektion von bis zu ca. 20 % kaum mehr wahrnehmbar ist.

Die Informationen, welche durch die diffraktiven Reliefstrukturen generiert werden, zeigen insbesondere optisch variable Effekte, wie blickwinkelabhängige Farbwechsel, kinematische Effekte, Hologramme, Glanz- und Streueffekte und dergleichen.

Zur Bildung der diffraktiven ersten und/oder zweiten Reliefstruktur oder von Teilen dieser werden vorzugsweise symmetrische oder asymmetrische Reliefstrukturen verwendet. Dabei können die Reliefstrukturen periodisch oder nicht periodisch ausgebildet sein.

Der Begriff der Symmetrie wird hier nicht im streng mathematischen Sinne gebraucht, sondern zur Abgrenzung von den asymmetrischen Reliefstrukturen, die nachstehend beschrieben sind. Es werden auch Reliefstrukturen als symmetrisch bezeichnet, die bei Faltung an einer Symmetrielinie nicht vollständig zu Deckung gebracht werden können, deren Flanken sich jedoch im Betrag ihrer Steigung so wenig voneinander unterscheiden, dass ein betrachtungsabhängige optischer Effekt nicht eintritt.

Unter einer asymmetrischen Reliefstruktur wird beispielsweise eine Sägezahnstruktur verstanden. Die Steigung der Sägezahnflanken unterscheidet sich dabei vorzugsweise signifikant. Insbesondere weist eine Flanke eine endliche Steigung auf, während die andere Flanke eine unendliche Steigung aufweist. Wird eine asymmetrische Reliefstruktur mit einer nichtkonstanten Periodenlänge / Spatialfrequenz eingesetzt, so kann vorgesehen sein, dass die diffraktive erste und/oder zweite Reliefstruktur eine Reliefstruktur ist, die ausgehend von einem Bezugspunkt in mindestens zwei Richtungen mit sich ändernder Spatialfrequenz oder Tiefe ausgebildet ist. Bei sich ändernder Spatialfrequenz ändert sich auch die Flankensteigung der asymmetrischen Reliefstruktur, d.h. ein zwischen der Flanke und einer zur Oberfläche der Reliefstruktur parallelen Hauptebene ausgebildeter Flankenwinkel wächst mit zunehmender Flankensteigung bzw. Flankensteilheit. Es kann vorgesehen sein, dass sich die Spatialfrequenz ausgehend vom Bezugspunkt erhöht, vorzugsweise kontinuierlich erhöht. Die Flankensteilheit nimmt also zum Rand der Reliefstruktur zu. Dabei können die geneigten Flanken auch Abschnitte von stetigen Kurven sein. Es handelt sich also um eine beugungsoptisch wirksame Struktur mit einer hinsichtlich der Spatialfrequenz und gegebenenfalls weiterer Gitterkonstanten über den Flächenbereich vorzugsweise kontinuierlich verändernden Reliefstruktur, die derart gestaltet ist, dass die jeweils einen Flanken der Gitterfurchen parallel zueinander und etwa parallel zu einer Senkrechten auf die Hauptebene der Reliefstruktur verlaufen, während sich der Winkel der jeweils anderen Flanken der Gitterflächen gegenüber der Hauptebene über den Flächenbereich im wesentlichen kontinuierlich ändert, wobei die Gittertiefe höchstens 10 $\mu$m beträgt.

Eine Reliefstruktur kann weiterhin durch ein Blazegitter gebildet sein. Bei dem Blazegitter handelt es sich um ein Beugungsgitter. Zwischen dem Eintrittswinkel $\Theta_{ein}$ und dem Austrittswinkel $\Theta_{aus}$ besteht an einem Blazegitter in Abhängigkeit von der Gitterkonstanten d, der Wellenlänge $\lambda$ und der Beugungsordnung n folgende Beziehung:

$$\sin \Theta_{aus} = \sin \Theta_{ein} + n * \lambda/d$$

Das heißt, polychromatisches Licht, wie beispielsweise Tageslicht, wird durch die Beugung am Blazegitter in seine Grundfarben zerlegt. Das Blazegitter ist durch die Wahl der Gitterkonstanten d jedoch als achromatisches Blazegitter ausbildbar, bei dem die farbigen Teilstrahlen mindestens der ersten Beugungsordnung in einem Betrachtungswinkelbereich wieder zusammengeführt werden und so wieder polychromatisches Licht aus dem Blazegitter austritt. Auf diese Weise können ca. 90 % des einfallendes Lichtes als gebündelter Strahl gebeugt werden, wodurch die Bildwirkung besonders kontrastreich ausgebildet ist. Von dieser Eigenschaft leitet sich der Name des Gitters ab (to blaze = funkeln).

Es kann vorteilhafterweise vorgesehen sein, dass das Blazegitter ein achromatisches Blazegitter mit einer Gitterkonstanten von 20 $\mu$m bis 3 $\mu$m, bevorzugt 10 $\mu$m und mit einer Profiltiefe von 0,3 $\mu$m bis 5 $\mu$m, bevorzugt 1,5 $\mu$m ist. In Abhängigkeit von der Profiltiefe können höhere Beugungsordnungen eine höhere Intensität ausbilden als die erste Beugungsordnung.

Weiter kann vorgesehen sein, dass das Blazegitter ein chromatisches Blazegitter mit einer Gitterkonstanten von kleiner als 2 $\mu$m ist, bevorzugt 1 $\mu$m ist. In diesem Fall leuchtet das Blazegitter bei Beleuchtung mit Tageslicht beim Kippen in den Regenbogenfarben auf.

Es kann weiter vorgesehen sein, dass eine Reliefstruktur als Mattstruktur ausgebildet ist. Bei der Mattstruktur handelt es sich um eine diffus Licht streuende Reliefstruktur, die daher matt erscheint. Eine solche Reliefstruktur kann typisch eine Strukturtiefe von $\leq 10$ $\mu$m aufweisen. Auch ein Fourier-Hologramm oder ein computergeneriertes Hologramm, ein sog. Kinoform, mit einem verborgenen Merkmal können als Mattstruktur wirken. Sie haben die Aufgabe, ein verborgenes Merkmal in Reflexion oder Transmission zu projizieren.

Das erfindungsgemäße Sicherheitselement zeigt auf beiden Seiten in Reflektion bzw. im Auflicht gesehen Informationen oder Teilinformationen, die jeweils nur durch eine der diffraktiven Reliefstrukturen generiert werden. Dies wird realisiert, indem zumindest ein Teil der Reliefstrukturen voneinander optisch entkoppelt werden, so dass besonders anspruchsvolle und interessante optische Effekte unabhängig voneinander auf beiden Seiten des Sicherheitselements ausgebildet werden können.

Wie bereits oben erwähnt ist es besonders bevorzugt, wenn die erste und die zweite Information sich zumindest bereichsweise voneinander unterscheiden. Eine Unterscheidung der Reliefstrukturen kann durch die Profilform, die Spatialfrequenz und/oder den Azimutwinkel oder auch durch Kenngrößen stochastischer Strukturen wie Mattstrukturen, wie beispielsweise die Rauhtiefe, die Korrelationslänge usw. gegeben sein. So kann beispielsweise durch die erste Reliefstruktur ein Zahlenwert als erste Information erzeugt werden, während nach dem Umwenden des Sicherheitselements ein, durch die zweite Reliefstruktur als zweite Information erzeugtes Portrait sichtbar wird.

Es ist aber genauso möglich, dass durch die erste Reliefstruktur ein Zahlenwert als erste Information erzeugt wird, und dass nach dem Umwenden des Sicherheitselements ein, durch die zweite Reliefstruktur als zweite Information erzeugter Zahlenwert in seitenrichtiger und/oder lagerichtigen (d.h. nicht auf dem Kopf stehenden) Darstellung sichtbar wird, wobei die erste und die zweite Information gleich sind.

Es ist weiterhin möglich, dass durch die erste Reliefstruktur ein farbiger Zahlenwert vor einem achromatischen Hintergrund als erste Information erzeugt wird, und dass nach einem horizontalen oder vertikalen Umwenden des Sicherheitselements ein, durch die zweite Reliefstruktur als zweite Information erzeugter achromatischer Zahlenwert vor einem farbigen Hintergrund sichtbar ist.

Besonders bevorzugt ist es, wenn die erste Reflektionsschicht die durch die zweite Reliefstruktur generierte zweite Information und gegebenenfalls weitere generierte Informationen vollständig verdeckt und wenn die zweite Reflektionsschicht die von der ersten Reliefstruktur generierte erste Information und gegebenenfalls weitere generierte Informationen vollständig verdeckt. Das Sicherheitselement vermittelt somit auf seinen beiden Seiten voneinander unabhängige Informationen, da die erste und die zweite Reliefstruktur vollständig optisch voneinander entkoppelt sind.

Es hat sich insbesondere bewährt, wenn die Strukturschicht auf einer ersten Seite die diffraktive erste Reliefstruktur und auf einer zweiten Seite die diffraktive zweite Reliefstruktur aufweist, wobei die erste Seite an die erste Reflektionsschicht angrenzt und die zweite Seite an die zweite Reflektionsschicht angrenzt.

Vorzugsweise sind die erste und die zweite Reflektionsschicht senkrecht zur Ebene der Strukturschicht gesehen überwiegend oder vollständig deckungsgleich angeordnet. Aufgrund der Übereinstimmung der Flächenausdehnung und Lage der beiden Reflektionsschichten zueinander auf der Strukturschicht lassen sich besonders ansprechende Sicherheitselemente erzeugen und eine optische Entkopplung der ersten Reliefstruktur von der zweiten Reliefstruktur in einfacher Weise realisieren. Besonders bevorzugt sind dabei Reflektionsschichten, die zumindest im Auflicht und insbesondere im Auflicht und im Durchlicht gesehen opak sind oder mit mindestens einer opaken Hilfsschicht hinterlegt sind.

Idealerweise bildet die erste Reflektionsschicht dem Betrachter zugewandt eine Vorderansicht mindestens eines Bildmotivs aus, wobei die Vorderansicht die von der ersten Reliefstruktur generierte erste Information zeigt, und die zweite Reflektionsschicht bildet dem Betrachter zugewandt eine Rückansicht des mindestens einen Bildmotivs aus, wobei die Rückansicht die durch die zweite Reliefstruktur generierte zweite Information zeigt. Das Bildmotiv kann das, einem Betrachter vornehmlich auffallende Hauptmotiv des Sicherheitselements ausbilden oder ein weniger auffallendes Hintergrundmotiv ausbilden, welches mit weiteren, auffälligeren Darstellungen kombiniert ist. Dabei können sich diese Darstellungen in der Vorderansicht und Rückansicht deutlich unterschieden.

Das erfindungsgemäße Sicherheitselement zeigt in deiner solchen Ausführungsform eine Vorderansicht eines Bildmotivs und nach Umwenden des Sicherheitselements die Rückansicht dieses Bildmotivs. Aufgrund der perfekten Übereinstimmungsenkrecht zur Ebene der Strukturschicht gesehen - im Hinblick auf eine Flächenausdehnung und eine Position der ersten Reflektionsschicht gegenüber der zweiten Reflektionsschicht blickt ein Betrachter im Bereich der Vorderansicht lediglich auf die erste Reflektionsschicht und im Bereich der Rückansicht lediglich auf die zweite Reflektionsschicht. Eine Kombination aus erster und zweiter Reflektionsschicht ist von keiner Seite des Sicherheitselements sichtbar. So ist insbesondere bei Verwendung gleicher Materialien zur Bildung der ersten und zweiten Reflektionsschicht für den Betrachter nicht zu erkennen, dass es sich um zwei getrennte, in unterschiedlichen Ebenen des Sicherheitselements vorliegende Reflektionsschichten handelt. Vorzugsweise ist das Bildmotiv im Auflicht und insbesondere im Auflicht und im Durchlicht gesehen opak, wobei allerdings der Gesamteindruck des Sicherheitselements für den Betrachter im Durchlicht gesehen transparent bleibt.

Generell kann in transparenten Bereichen des Sicherheitselements eine filigrane Bedruckung vorliegen, ohne deren Transparenz wesentlich zu beeinträchtigen.

Werden unterschiedliche erste und zweite Reliefstrukturen im Bereich des Bildmotivs verwendet, so sind aufgrund der optischen Entkopplung der Reliefstrukturen mittels der beiden Reflektionsschichten, gegebenenfalls mit Hilfe einer oder mehrerer opaken Hilfsschichten, in der Vorderansicht andere Informationen auslesbar als in der Rückansicht, so dass dem Betrachter der Eindruck vermittelt wird, dass es sich um ein dreidimensionales Objekt handelt, welches in das Sicherheitselement integriert ist und das Bildmotiv bereitstellt.

Ein derartiges Sicherheitselement ist schwer nachzuahmen, da eine Anordnung von erster und zweiter Reflektionsschicht in perfektem Register zueinander technisch anspruchsvoll ist. So kann das menschliche Auge bereits zwei getrennte Reflektionsschichten erkennen, wenn senkrecht zur Ebene der Strukturschicht gesehen ein Abstand zwischen dem Umriss der ersten Reflektionsschicht und dem Umriss der zweiten Reflektionsschicht von > 5 $\mu$m vorliegt, sofern sich die Reflektionsschichten in Farbe und/oder angrenzender Reliefstruktur unterscheiden.

Es hat sich besonders bewährt, wenn das mindestens eine Bildmotiv sich aus zumindest im Auflicht gesehen opaken Bildelementen und transparenten Bildelementen zusammensetzt, wobei die zumindest im Auflicht opaken Bildelemente der Vorderansicht durch die erste Reflektionsschicht und gegebenenfalls die mindestens eine erste opake Hilfsschicht gebildet sind, wobei die zumindest im Auflicht opaken Bildelemente der Rückansicht durch die zweite Reflektionsschicht und gegebenenfalls die mindestens eine zweite opake Hilfsschicht gebildet sind, und wobei die transparenten Bildelemente durch transparente Bereiche der mindestens einen Strukturschicht, optional in Kombination mit mindestens einer weiteren transparenten Schicht, gebildet sind.

Dadurch lassen sich besonders hochwertige und ästhetisch ansprechende Sicherheitselemente mit interessanten, schwer nachahmbaren Bildmotiven ausbilden. Dabei sind die zumindest im Auflicht gesehen opaken Bildelemente insbesondere im Auflicht und im Durchlicht gesehen opak. Die einzelnen zumindest im Auflicht gesehen opaken Bildelemente weisen dabei vorzugsweise eine Flächenausdehnung im Bereich von 1 $\mu$m$^2$ bis 400 mm$^2$, insbesondere im Bereich von 1 $\mu$m$^2$ bis 2500 $\mu$m$^2$ auf. Insbesondere entspricht die minimale Ausdehnung eines opaken Bildelements in einer Richtung mindestens einem mittleren Abstand zwischen der ersten und der zweiten Reflektionsschicht.

Die opaken Bildelemente können transparente Bildelemente umschließen oder begrenzen, beispielsweise in Form eines Rahmens oder Gitters, und/oder von einem transparenten Bildelement umschlossen sein und/oder rasterförmig angeordnet sein, beispielsweise in Form eines Linienrasters und/oder Punktrasters, wodurch sich Halbtonbilder in hoher Auflösung erzeugen lassen.

Die Flächenausdehnung eines einzelnen opaken Bildelements kann so groß gewählt sein, dass es für das menschliche Auge sichtbar ist oder aber so klein gewählt sein, dass das Auflösungsvermögen des menschlichen Augen nicht ausreicht, um es zu erkennen, z.B. in Form von Rasterpunkten zur Bildung von Halbtonbildern. Die bevorzugten Parameter einer derartigen Rasterung sind weiter unten noch detailliert aufgeführt.

Es hat sich bewährt, wenn das mindestens eine Bildmotiv eine figürliche Darstellung, ein Portrait, ein alphanumerisches Zeichen, ein Text, ein graphisches Muster, ein Symbol oder ein Logo ist. Unter einer figürlichen Darstellung wird dabei eine Darstellung aus dem Bereich Flora, Fauna, Technik, Architektur, Sport oder dergleichen verstanden. Auch eine Kombination unterschiedlicher Bildmotive, beispielsweise eines Portraits mit einem Text usw., hat sich bewährt.

Eine Reflektionsschicht bzw. ein daraus gebildetes Bildelement wird dann als im Durchlicht opak bezeichnet, wenn im sichtbaren Wellenlängenbereich im Durchlicht die optische Dichte von > 1 vorliegt.

Es hat sich bewährt, wenn die mindestens eine erste opake Hilfsschicht und/oder die mindestens eine zweite opake Hilfsschicht durch mindestens eine Metallschicht und/oder mindestens eine Druckfarbenschicht und/oder mindestens eine opak eingefärbte Lackschicht, welche auch eine Photoresistschicht sein kann, und/oder opake Bereiche der Strukturschicht gebildet ist/sind.

Die erste und/oder zweite Reflektionsschicht ist/sind durch mindestens eine Metallschicht und/oder mindestens eine dielektrische Schicht gebildet.

Das Sicherheitselement kann außer der zumindest bereichsweise transparenten Strukturschicht mindestens eine weitere transparente Schicht oder Schichtenfolge aufweisen, welche gegebenenfalls auch farbig transparent ausgebildet sein kann/können, die entweder vollflächig oder bereichsweise auf dem Sicherheitselement vorliegen kann/können. Als weitere transparente Schicht(en) kommen Lackschichten, Kunststoffschichten oder -folien, dielektrische Schichten, metallische Dünnfilme mit besonders geringer Schichtdicke, Dünnfilm-Interferenzschichtstapel mit blickwinkelabhängigem Interferenz-Farbwechseleffekt oder Flüssigkristallschichten in Frage.

Bei Anordnung einer transparenten cholesterischen Flüssigkristallschicht mit Farbwechsel-Effekt oder eines transparenten Dünnfilm-Interferenzschichtstapels mit blickwinkelabhängigem Interferenz-Farbwechseleffekt zumindest in transparenten Bereichen des Sicherheitselements tritt der jeweilige Farbeffekt verstärkt in Erscheinung, wenn das Sicherheitselement vor einem dunklen Hintergrund betrachtet wird.

In transparenten Bereichen des Sicherheitselements kann ein transparentes Hologramm oder Kinegram® vorhanden sein, das von der ersten und/oder zweiten Reliefstruktur generiert wird und/oder ein blickwinkelabhängiger Farbwechseleffekt auftreten.

Es hat sich bewährt, wenn gegebenenfalls vorhandene transparente Lackschichten, Kunststoffschichten oder -folien des Sicherheitselements wie auch die Strukturschicht des Sicherheitselements lumineszierende oder photochrome Substanzen enthalten, die bei normaler Beleuchtung farblos transparent sind, jedoch bei Anregung, beispielsweise mit IR- oder UV-Strahlung, eine Eigenfarbe zeigen.

Es hat sich bewährt, wenn die erste und die zweite Reflektionsschicht sich in Material und/oder Farbe nicht unterscheiden. Vorzugsweise weisen die erste und die zweite Reflektionsschicht dabei die gleiche Schichtdicke auf.

So sind die erste und zweite Reflektionsschicht vorzugsweise aus dem/der gleichen Metall/Metall-Legierung, insbesondere aus Aluminium, Chrom, Kupfer, Gold oder Silber, oder dem gleichen dielektrischen Material, insbesondere einem transparenten Material mit hohem Brechungsindex, wie ZnS, $TiO_2$ usw. gebildet.

Es hat sich aber als genauso vorteilhaft erwiesen, wenn die erste und die zweite Reflektionsschicht sich in Material und/oder Farbe unterscheiden. So ist die erste Reflektionsschicht vorzugsweise aus Metall oder einer Metall-Legierung gebildet. Die zweite Reflektionsschicht ist dann vorzugsweise aus einem Metall/einer Metall-Legierung unterschiedlicher Farbe oder aus einer dielektrischen Schicht gebildet. Ein unterschiedlicher Farbeffekt an zwei Reflektionsschichten aus gleichem Material kann alternativ auch erzeugt werden, indem eine oder beide Reflektionsschichten auf ihrer dem Betrachter zugewandten Seite mit einer farbigen transparenten Schicht bedeckt ist/sind.

Es hat sich bewährt, wenn die Strukturschicht eine Schichtdicke im Bereich von 0,2 bis 15 $\mu$m, insbesondere im Bereich von 0,3 bis 3 $\mu$m aufweist. Bei einer derartigen Schichtdicke der Strukturschicht erkennt das menschliche Auge nicht, dass die erste und zweite Reflektionsschicht sich auf unterschiedlichen Ebenen innerhalb des Sicherheitselements befinden, wobei Tiefenunterschiede bis zu 0,1 mm mit einem unbewaffneten menschlichen Auge nicht erkannt werden können. Zu beachten ist dabei generell, dass die Schichtdicke der Strukturschicht größer ist als die Summe der maximalen Strukturtiefen der ersten und der zweiten Reliefstruktur, um eine gegenseitige Beeinflussung der Reliefstrukturen auszuschließen.

Vorzugsweise ist die Strukturschicht insgesamt transparent, insbesondere farblos transparent ausgebildet.

Es hat sich bewährt, wenn das Sicherheitselement im Durchlicht gesehen im Bereich mindestens einer der Reflektionsschichten sichtbar unterschiedlich transmissive Bereiche aufweist, die eine weitere Information, insbesondere in Form eines Musters, Texts, Bilds, Portraits, Logos oder dergleichen zeigen. Dies lässt sich dadurch erreichen, dass eine oder mehrere Reflektionsschichten mit im Auflicht gesehen durch das menschliche Auge nicht erkennbar kleinen Öffnungen ausgebildet sind und/oder unterschiedlich dick ausgebildet sind, so dass im Durchlicht gesehen im Bereich der Reflektionsschicht(en) sichtbares Licht zumindest bereichsweise und insbesondere derart, dass sich die weitere Information zeigt, durch das Sicherheitselement hindurchgelangen kann. Überlagern sich zwei oder mehrere Reflektionsschichten im Durchlicht gesehen senkrecht zur Ebene der Strukturschicht, so ist die Transmission einer jeden Reflektionsschicht lokal entsprechend einzustellen, damit am Sicherheitselement gegebenenfalls auch im Bereich der sich überlagernden Reflektionsschichten noch eine sichtbare Transmission erreicht werden kann.

Es ist bevorzugt, wenn eine im Auflicht opak erscheinende Reflektionsschicht transparente Bereiche und/oder Öffnungen aufweist, deren Dimensionen, zumindest in einer Richtung, unterhalb der Auflösungsgrenze des menschlichen Auges, also kleiner als etwa 0,3 mm betragen. Besonders bevorzugt sind Öffnungen, deren Dimensionen, zumindest in einer Richtung, im Bereich von 1 bis 250 $\mu$m, insbesondere im Bereich von 2 bis 100 $\mu$m liegen, und insbesondere im Bereich von 5 bis 80 $\mu$m liegen. Derartige transparente Bereiche oder Öffnungen sind für das menschliche Auge im Auflicht unsichtbar, jedoch im Durchlicht aufgrund der erhöhten Transmission von Licht problemlos erkennbar.

Weiterhin hat es sich bewährt, wenn eine im Auflicht opak erscheinende Reflektionsschicht transparente Bereiche und/oder Öffnungen aufweist, wobei die mittlere Flächendichte der transparenten Bereiche oder Öffnungen in der opaken Schicht < 10 % beträgt. Derartige transparente Bereiche oder Öffnungen sind für das menschliche Auge im Auflicht im Wesentlichen ebenfalls unsichtbar, jedoch im Durchlicht aufgrund der erhöhten Transmission von Licht problemlos erkennbar.

Außerdem ist es von Vorteil, wenn eine im Auflicht opak erscheinende Reflektionsschicht Bereiche mit unterschiedlicher Schichtdicke aufweist. Die Bereiche mit unterschiedlichen Schichtdicken können für das menschliche Auge im Auflicht durchgehend opak erscheinen, jedoch sind Bereiche mit geringerer Schichtdicke im Durchlicht aufgrund der erhöhten Transmission von Licht problemlos von Bereichen mit höherer Schichtdicke unterscheidbar.

In transparenten Bereichen, welche gleichwertig zu einer durchgehenden Öffnung in einer im Auflicht opak erscheinenden Reflektionsschicht wahrgenommen werden, kann das zur Bildung der Reflektionsschicht verwendete Material in so geringer Schichtdicke vorliegen, dass es keinen wesentlichen bzw. wahrnehmbaren Einfluss auf die Transmissionseigenschaften des Sicherheitselements besitzt.

Die Strukturierung einer Reflektionsschicht, bzw. die Bildung von Öffnungen oder transparenten Bereichen, kann dabei gemäß einem Verfahren nach DE 102004042136 A1 realisiert werden. Hierbei wird die Schichtdicke der Schicht dadurch eingestellt, dass das Material zur Bildung der Schicht auf eine mit diffraktiven Oberflächenstrukturen versehene Fläche gleichmäßig aufgetragen wird, wobei sich abhängig vom Tiefen-zu-Breiten-Verhältnis der Oberflächenstrukturen eine lokal unterschiedliche effektive Schichtdicke einstellt.

Eine Reflektionsschicht kann in den, im Auflicht opak erscheinenden Bereichen zumindest bereichsweise eine sich kontinuierlich ändernde Schichtdicke aufweisen. Alternativ oder in Kombination dazu kann eine Reflektionsschicht in den, im Auflicht opak erscheinenden Bereichen zumindest bereichsweise eine sich stufenweise ändernde Schichtdicke aufweisen. Die Ausbildung der unterschiedlichen Schichtdicke erzeugt eine im Durchlicht gesehen unterschiedliche Transmissivität bzw. optische Dichte und kann ebenso gemäß einem Verfahren nach DE 102004042136 A1 realisiert sein.

Weiterhin hat es sich als vorteilhaft erwiesen, wenn die im Auflicht opak erscheinende Reflektionsschicht Öffnungen aufweist derart, dass diese Schicht in Form eines feinen Punkt- oder Linienrasters mit einer Rasterweite kleiner 300 $\mu$m strukturiert ist. Besonders bevorzugt ist es dabei, wenn die Schicht in Form eines aperiodischen Punkt- oder Linienrasters strukturiert ist. Es hat sich bewährt, wenn opake Bildelemente zur Rasterung eingesetzt werden, deren Dimensionen, zumindest in einer Richtung, unterhalb der Auflösungsgrenze des menschlichen Auges, also kleiner als etwa 0,3 mm betragen. Besonders bevorzugt sind opake Bildelemente, deren Dimensionen, zumindest in einer Richtung, im Bereich von 1 bis 250 $\mu$m, insbesondere im Bereich von 2 bis 100 $\mu$m liegen, und insbesondere im Bereich von 5 bis 80 $\mu$m liegen.

Unter dem Begriff "Punkt" werden dabei nicht nur kreisrunde Bildpunkte verstanden, sondern auch andere geometrische Formen wie dreieckige, rechteckige, elliptische, usw. Bildpunkte. Auch Bildpunkte in Form von Symbolen, bildlichen Darstellungen, alphanumerischen Zeichen oder Zeichenfolgen sind möglich. Die Punkte oder Linien sind dabei entweder in einem gleichmäßigen Rasterabstand oder einem sich lokal oder stetig ändernden Rasterabstand angeordnet. Alternativ oder in Kombination dazu kann die Flächenausdehnung der Punkte oder Linien variieren.

Vorzugsweise beträgt die mittlere Flächenbelegung der opaken Bildbereiche auf dem Sicherheitselement weniger als 50% und liegt insbesondere im Bereich von 10 bis 30%. Das Sicherheitselement erschient für den Betrachter somit auch im Auflicht gesehen teiltransparent und lässt auf beiden Seiten unterschiedliche diffraktive Effekte erkennen. Gleichzeitig kann im Durchlicht gesehen die Transmission des Sicherheitselements lokal erkennbar unterschiedlich sein.

Die Aufgabe wird für das Sicherheitsdokument gelöst, indem das mindestens eine Sicherheitselement in mindestens einem transparenten Bereich des Sicherheitsdokuments oder überlappend dazu angeordnet ist. Dabei kann der transparente Bereich zu 100% transparent ausgebildet sein oder in bis zu 25% seiner Fläche eine opake Bedruckung oder dergleichen aufweisen, beispielsweise in Form eines filigranen musterförmigen Aufdrucks, der sich gegebenenfalls in angrenzende Bereiche des Sicherheitsdokuments fortsetzt.

Das Sicherheitselement bildet dabei vorzugsweise ein so genanntes Fensterelement oder ist in Form eines Sicherheitsfadens ausgestaltet. Ein als Fensterelement eingesetztes Sicherheitselement kann dabei als Authentifizierungsschild eingesetzt werden, um beispielsweise auf dem Sicherheitsdokument angeordnete versteckte Informationen sichtbar zu machen. Hierzu ist beispielsweise ein Moire-Muster auf dem Sicherheitsdokument vorhanden, welches versteckte Informationen beinhaltet, die erst sichtbar werden, wenn das Moire-Muster mit dem Authentifizierungsschild überlagert wird. Dazu wird das Sicherheitsdokument beispielsweise gefaltet, um den Authentifizierungsschild mit dem Muster zur Deckung zu bringen, oder zwei Sicherheitsdokumente werden zum gegenseitigen Auslesen der versteckten Informationen verwendet.

Es hat sich bewährt, wenn das Sicherheitsdokument ein transluzentes oder im Auflicht und Durchlicht gesehen opakes Trägersubstrat aufweist und in dem mindestens einen transparenten Bereich eine Fensteröffnung im Trägersubstrat vorliegt, so dass das mindestens eine Sicherheitselement in der Fensteröffnung oder diese überspannend angeordnet werden kann. Das Sicherheitselement kann demnach von beiden Seiten des Sicherheitsdokuments erkannt werden.

Weiterhin hat es sich bewährt, wenn das Sicherheitsdokument ein transparentes Trägersubstrat, insbesondere aus PVC, PET oder PC, aufweist und das mindestens eine Sicherheitselement auf dem Trägersubstrat angeordnet oder im Trägersubstrat eingebettet ist. Es können hier zusätzlich eine oder mehrere opake Farbschichten oder -folien vorhanden sein, die das Trägersubstrat auf einer oder beiden Seiten bereichsweise bedecken, allerdings den transparenten Bereich mit dem mindestens einen Sicherheitselement aussparen. Auch ein bereichsweise transparentes Trägersubstrat kann zum Einsatz kommen, in dessen transparenten Bereichen das mindestens eine Sicherheitselement angeordnet oder eingebettet wird.

Ein erfindungsgemäßes Sicherheitselement in Form eines Sicherheitsfadens kann aber auch so in ein Sicherheitsdokument, wie beispielsweise eine Banknote, eingebettet sein, dass auf einer Seite des Sicherheitsdokuments abschnittsweise die Vorderseite des Sicherheitsfadens sichtbar ist und auf der gegenüberliegenden Seite des Sicherheitsdokuments abschnittsweise die Rückseite des Sicherheitsfadens sichtbar ist, wobei im Bereich dieser Abschnitte auf der jeweiligen gegenüberliegenden Seite des Sicherheitsdokuments - zumindest im Auflicht gesehen - der Sicherheitsfaden nicht sichtbar ist. Die auf einer Seite des Sicherheitsdokuments sichtbaren Abschnitte des Sicherheitsfadens sind demnach jeweils rückseitig mit dem Trägersubstrat des Sicherheitsdokuments, beispielsweise aus Papier, bedeckt. Es hat sich als vorteilhaft erwiesen, wenn das Sicherheitsdokument mindestens eine transparente Schutzschicht aufweist, welche das Sicherheitsdokument inklusive dem mindestens einen Sicherheitselement vor einer mechanischen Beschädigung und/oder vor sonstigen Beeinträchtigungen, beispielsweise durch Feuchtigkeit, schützt. Vorzugsweise weist das Sicherheitselement zwei transparente Schutzschichten auf, zwischen welchen zumindest das Trägersubstrat und das mindestens eine Sicherheitselement, gegebenenfalls auch weitere Schichten des Sicherheitsdokuments, eingeschlossen sind.

Idealerweise ist das Sicherheitsdokument ein Ausweis, ein Pass, ein Zertifikat, eine Bankkarte, eine Kreditkarte, eine Telefonkarte, ein Geldschein, ein Führerschein, ein Visum oder dergleichen.

Die Aufgabe wird für ein erstes Verfahren zur Herstellung eines erfindungsgemäßen Sicherheitselements mit folgenden Schritten gelöst:

a) Bereitstellen einer transparenten ersten Replizierschicht;
b) Bilden einer diffraktiven Masterreliefstruktur auf einer ersten Oberfläche der ersten Replizierschicht;
c) Bilden der bereichsweise ausgebildeten ersten Reflektionsschicht, gegebenenfalls weiterhin mindestens einer bereichsweise ausgebildeten ersten opaken Hilfsschicht auf der ersten Oberfläche;
d) Bilden der zumindest bereichsweise transparenten Strukturschicht durch eine zweite Replizierschicht, welche auf der ersten Reflektionsschicht und gegebenenfalls der mindestens einen ersten opaken Hilfsschicht und davon freien Bereichen der ersten Oberfläche angeordnet wird;
e) Bilden der diffraktiven zweiten Reliefstruktur auf einer zweiten Seite der Strukturschicht; und
f) Bilden der bereichsweise ausgebildeten zweiten Reflektionsschicht auf der zweiten Seite der Strukturschicht in einer Schichtdicke, bei der die zweite Reliefstruktur auf der, der Strukturschicht abgewandten Seite der zweiten Reflektionsschicht abgeformt wird.

Dieses Verfahren ermöglicht es, die Strukturschicht besonders dünn und daher nichtselbsttragend auszubilden. Wird die erste Replizierschicht als von der Strukturschicht ablösbar ausgebildet oder auf einer ablösbaren Trägerfolie bereitgestellt, liegt ein Aufbau vor, wie er bei Transferfolien üblich ist. Das Sicherheitselement kann demnach in eine Transferfolie integriert vorliegen und durch Prägen auf ein Sicherheitsdokument appliziert werden. Die erste Replizierschicht kann aber auch selbsttragend sein oder auf einer transparenten Trägerfolie bereitgestellt sein, wobei die erste Replizierschicht und gegebenenfalls die Trägerfolie einen festen, permanenten Verbund mit den weiteren Schichten des Sicherheitselements ausbilden, so dass das fertige Sicherheitselement in Form einer Laminierfolie vorliegt.

Es hat sich bewährt, wenn die erste Reflektionsschicht und/oder die zweite Reflektionsschicht opak ausgebildet wird/werden. Alternativ kann die erste und/oder die zweite Reflektionsschicht transparent ausgebildet werden und senkrecht zur Ebene der Strukturschicht gesehen mindestens eine erste und/oder mindestens eine zweite opake Hilfsschicht deckungsgleich zu der/den transparenten Reflektionsschicht(en) angeordnet werden.

Die Aufgabe wird weiterhin durch ein zweites Verfahren zur Herstellung eines erfindungsgemäßen Sicherheitselements mit folgenden Schritten gelöst:

g) Bereitstellen einer transparenten Strukturschicht;
h) Bilden der diffraktiven ersten Reliefstruktur auf einer ersten Seite und der diffraktiven zweiten Reliefstruktur auf einer zweiten Seite der Strukturschicht;
i) Bilden der zumindest bereichsweise ausgebildeten ersten Reflektionsschicht und gegebenenfalls mindestens einer ersten opaken Hilfsschicht auf der ersten Seite der Strukturschicht; und
k) Bilden der zumindest bereichsweise ausgebildeten zweiten Reflektionsschicht und gegebenenfalls mindestens einer zweiten opaken Hilfsschicht auf der zweiten Seite der Strukturschicht.

Dieses Verfahren ist insbesondere geeignet, selbsttragende Strukturschichten zu verarbeiten. Es hat sich dabei bewährt, wenn die erste und die zweite Reliefstruktur gleichzeitig durch Prägen gebildet werden. Dies erfolgt beispielsweise dadurch, dass die selbsttragende Strukturschicht zwischen zwei Prägewalzen hindurchgefördert wird, welche jeweils mit einem Oberflächenrelief versehen sind, so dass die erste und die zweite Reliefstruktur bei geeignetem Andruck der Prägewalzen und geeigneter Temperaturführung in der Strukturschicht ausgebildet werden. Dabei kann eine Registerhaltigkeit der beiden Reliefstrukturen in besonders einfacher Weise sichergestellt werden. Das fertige Sicherheitselement liegt vorzugsweise in Form einer Laminierfolie vor.

Dabei hat es sich bewährt, wenn die mindestens eine erste und/oder zweite opake Hilfsschicht gebildet wird, indem die Strukturschicht bereichsweise belichtet wird und ein in der Strukturschicht enthaltenes transparentes Farbmittel lediglich in den belichteten Bereichen in ein opakes Farbmittel umgewandelt wird.

Besonders bevorzugt ist es, wenn die Reliefstrukturen, also für das erste Verfahren die Masterreliefstruktur und die zweite Reliefstruktur und für das zweite Verfahren die erste und die zweite Reliefstruktur, durch Prägen, insbesondere durch eine thermische Replikation oder eine UV-Replikation, gebildet werden. Bei der thermischen Replikation wird ein beheiztes Prägewerkzeug mit einem Oberflächenrelief gegen eine thermoplastische Replizierschicht oder thermoplastische Strukturschicht gedrückt und die gewünschte Reliefstruktur abgeformt. Bei der UV-Replikation wird ein UV-härtender Lack verwendet, in welchen das Prägewerkzeug gedrückt und welcher gleichzeitig mit UV-Strahlung beaufschlagt und gehärtet wird, um eine Reliefstruktur abzuformen.

Es hat sich bewährt, wenn in Schritt c) oder Schritt i) des jeweiligen Verfahrens die erste Reflektionsschicht vollflächig auf die erste Replizierschicht oder die Strukturschicht aufgebracht wird und diese anschließend partiell entfernt wird. Dazu eignen sich insbesondere Verfahren, wie sie in der WO 2006/084685 A2 bereits hinreichend beschrieben wurden. Weitere geeignete Verfahren zur Erzeugung partiell ausgebildeter Reflektionsschichten sind ein partielles Aufdrucken eines Ätzmediums oder ein partielles Aufdrucken eines Schutzlacks mit anschließendem Ätzen in einem Ätzbad.

Besonders bevorzugt ist es, wenn auf die vollflächig gebildete erste Reflektionsschicht vollflächig eine erste Photoresistschicht aufgebracht wird, wenn die erste Photoresistschicht partiell belichtet und entfernt wird, wenn die erste Reflektionsschicht in den Bereichen durch Ätzen entfernt wird, in denen die erste Photoresistschicht entfernt wurde, und wenn gegebenenfalls die verbliebenen Bereiche der ersten Photoresistschicht entfernt werden oder als eine opake Hilfsschicht verwendet werden.

Dabei kann eine herkömmliche Belichtung über eine Belichtungsmaske erfolgen oder aber ein Verfahren zur Belichtung des Photoresists eingesetzt werden, wie es in der WO 2006/084685 A2 beschrieben ist. Hier erfolgt die Belichtung der ersten Photoresistschicht durch die erste Reflektionsschicht hindurch, wobei die partielle Belichtung der ersten Photoresistschicht in Abhängigkeit von der Ausgestaltung und/oder Anordnung der ersten Reliefstruktur erfolgt.

Weiterhin hat es sich bewährt, wenn in Schritt f) oder Schritt k) des jeweiligen Verfahrens die zweite Reflektionsschicht vollflächig aufgebracht wird und anschließend partiell entfernt wird. Dazu eignen sich insbesondere auch die Verfahren, wie sie in der WO 2006/084685 A2 bereits hinreichend beschrieben wurden.

Besonders bevorzugt ist es, wenn auf die vollflächig ausgebildete zweite Reflektionsschicht vollflächig eine zweite Photoresistschicht aufgebracht wird, wenn die zweite Photoresistschicht partiell belichtet und entfernt wird, wenn die zweite Reflektionsschicht in den Bereichen durch Ätzen entfernt wird, in denen die zweite Photoresistschicht entfernt wurde, und wenn gegebenenfalls die verbliebenen Bereiche der zweiten Photoresistschicht entfernt werden. Sind die verbliebenen Bereiche der Photoresistschicht farbig transparent, so kann damit eine Einfärbung der zweiten Reflektionsschicht erzeugt werden.

Auch hier kann eine herkömmliche Belichtung über eine Belichtungsmaske erfolgen oder aber ein Verfahren zur Belichtung des Photoresists eingesetzt werden, das ähnlich dem in der WO 2006/084685 A2 beschrieben ist. Dabei erfolgt die Belichtung der zweiten Photoresistschicht durch die erste und die zweite Reflektionsschicht hindurch, wobei die partielle Belichtung der zweiten Photoresistschicht in Abhängigkeit von der Ausgestaltung und/oder Anordnung der ersten Reliefstruktur und/oder der zweiten Reliefstruktur erfolgt.

Besonders überraschend ist hierbei, dass eine gezielte partielle Belichtung der zweiten Photoresistschicht nicht nur durch eine Reliefstruktur und eine Reflektionsschicht hindurch erfolgen kann, wie es in der WO 2006/084685 A2 vorgeschlagen wird, sondern dass auch eine Belichtung durch zwei Reliefstrukturen und zwei Reflektionsschichten hindurch, die im Strahlengang hintereinander folgen, zu einer gezielten partiellen Belichtung der Photoresistschicht ausgenutzt werden kann. Die Durchlässigkeit für die Belichtungsstrahlung ergibt sich dabei im Strahlengang als Summe der Strahlungsdurchlässigkeit der ersten Reflektionsschicht und der Strahlungsdurchlässigkeit der zweiten Reflektionsschicht.

Die Figuren 1a bis 5b sollen die Erfindung beispielhaft erläutern. So zeigt

Figur 1a        ein Sicherheitselement mit einem Bildmotiv, das unter anderem Heißluftballone zeigt;

Figur 1b        das Sicherheitselement aus Figur 1 a nach dem Umwenden;

Figuren 2a bis 2i        ein Verfahren zur Herstellung des Sicherheitselements gemäß den Figuren 1a, 1b in vereinfachter Darstellung;

Figur 3a        eine selbsttragende Strukturschicht mit diffraktiven ersten und zweiten Reliefstrukturen;

Figur 3b          ein Sicherheitselement mit einer Strukturschicht gemäß Figur 3a; und

Figuren 4a bis 4g     ein weiteres Verfahren zur Herstellung eines Sicherheitselements mit einer opaken Hilfsschicht im Querschnitt;

Figuren 5a bis 5d     ein weiteres Verfahren zur Herstellung eines Sicherheitselements mit einer opaken Hilfsschicht im Querschnitt; und

Figuren 6a und 6b     Sicherheitsdokumente mit einem Sicherheitselement.

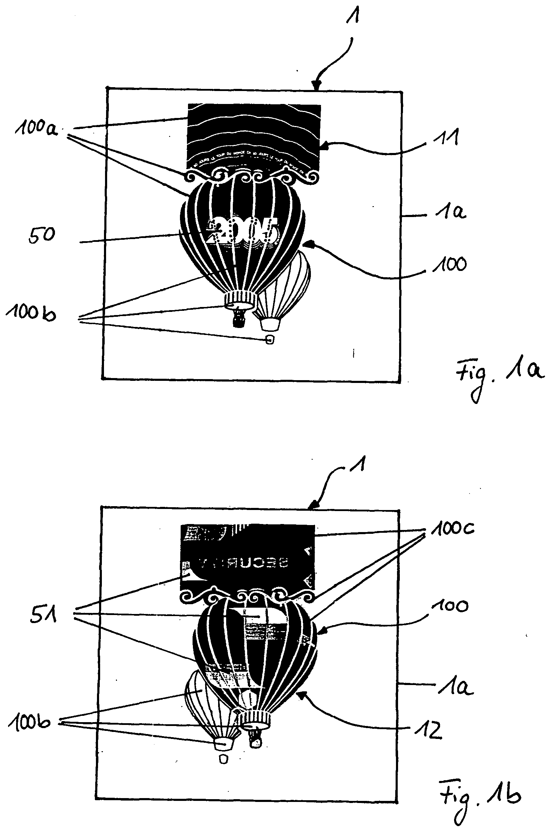

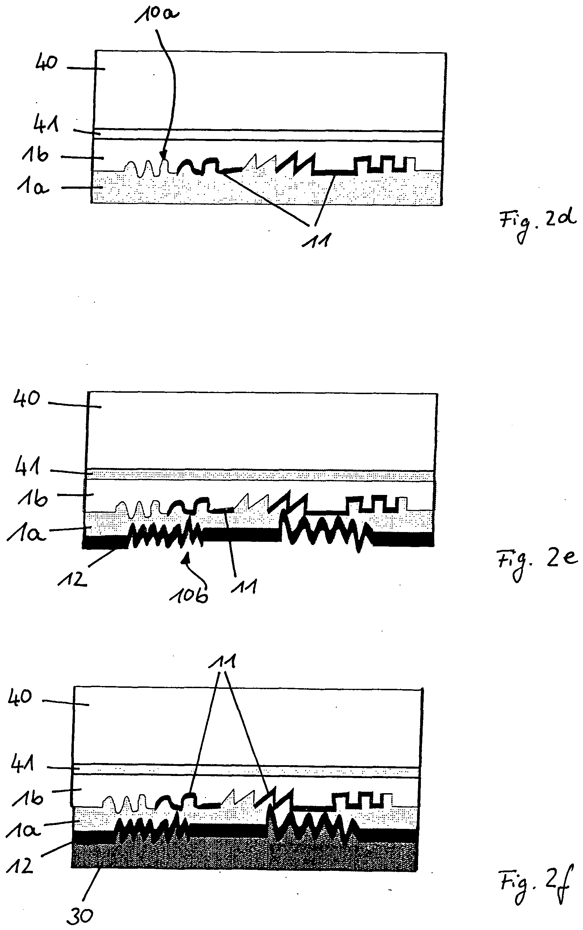

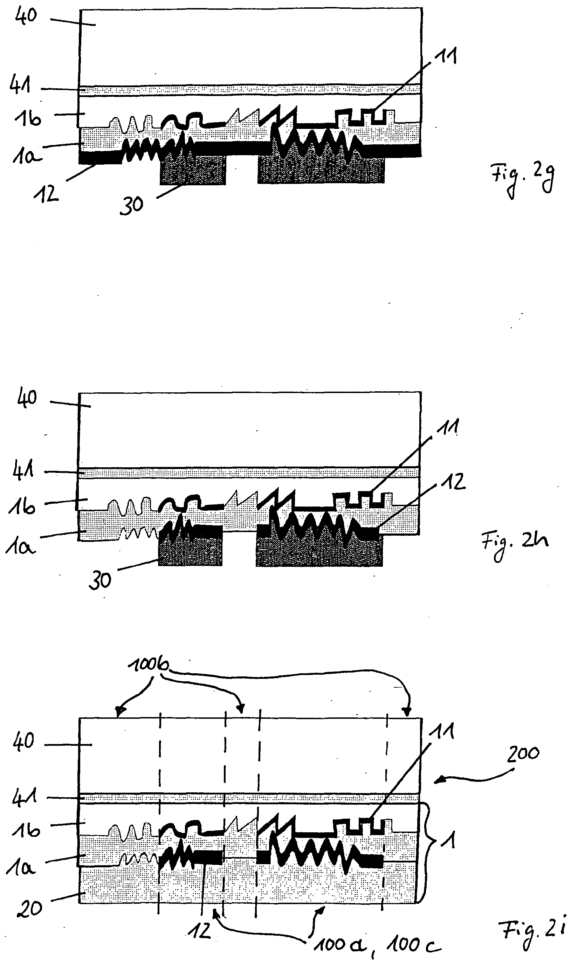

Figur 1 a zeigt ein Sicherheitselement 1 mit einem Bildmotiv 100, das unter anderem Heißluftballone und weitere dekorative Elemente zeigt. Auf einer transparenten Strukturschicht 1a befindet sich dem Betrachter zugewandt die erste Reflektionsschicht 11 aus im Auflicht und im Durchlicht gesehen opakem Aluminium, welche eine Vorderansicht des Bildmotivs 100 mit einer Vielzahl opaker Bildelemente 100a ausbildet. Die transparenten Bildelemente 100b sind von der Strukturschicht 1 a und weiteren transparenten Schichten 40, 41,1 b, 20 (siehe Figur 2i) gebildet. Die opaken Bildelemente 100a zeigen weiterhin eine erste holographische Information 50 in Form der Zahl "2005", welche durch eine erste diffraktive Reliefstruktur 10a (siehe Figur 2d) generiert wird. Die erste Information 50 ist dabei im Bereich der dünnen transparenten linienförmigen Bereiche 100b (Lage angedeutet auch mittels punktierter Linien) innerhalb des Ballons unsichtbar und im Übrigen im Bereich der opaken Bildelemente 100a von der ersten Reflektionsschicht 11 opak hinterlegt.

Figur 1b zeigt das Sicherheitselement 1 aus Figur 1a von der anderen Seite, wobei die Rückansicht des Bildmotivs 100 erkennbar wird. Auf der transparenten Strukturschicht 1a befindet sich dem Betrachter zugewandt die zweite Reflektionsschicht 12 aus Aluminium, welche eine Vorderansicht des Bildmotivs 100 mit einer Vielzahl opaker Bildelemente 100c ausbildet. Die transparenten Bildelemente 100b sind von der Strukturschicht 1 a und weiteren transparenten Schichten 1 b, 20 (siehe Figur 2i) gebildet. Die opaken Bildelemente 100c zeigen eine zweite Information 51 in Form von Hologrammen, welche durch eine zweite diffraktive Reliefstruktur 10b (siehe Figur 2e) generiert wird. Die zweite Information 51 ist dabei im Bereich der dünnen transparenten linienförmigen Bereiche 100b innerhalb des Ballons unsichtbar und im Übrigen im Bereich der opaken Bildelemente 100c von der zweiten Reflektionsschicht 12 opak hinterlegt.

Dabei ist gemäß Figur 1a bei Betrachtung des Bildmotivs 100 in der Vorderansicht lediglich die erste Reflektionsschicht 11 sichtbar, während bei Betrachtung des Bildmotivs 100 in der Rückansicht gemäß Figur 1b lediglich die zweite Reflektionsschicht 12 sichtbar ist. Dadurch sind diffraktive optisch variable Effekte inklusive der ersten Information 50 der ersten Reliefstruktur 10a nur in der Vorderansicht des Bildmotivs 100 und die diffraktiven optisch variablen Effekte inklusive der zweiten Information der zweiten Reliefstruktur 10b lediglich in der Rückansicht des Bildmotivs 100 erkennbar. Die erste Reliefstruktur 10a ist optisch vollständig von der zweiten Reliefstruktur 10b entkoppelt, da die erste und die zweite Reflektionsschicht 11, 12 senkrecht zur Ebene der Strukturschicht 1 a gesehen deckungsgleich mit gleicher Flächenausdehnung hintereinander angeordnet sind. Es ergibt sich für den Betrachter des Sicherheitselements 1 der Eindruck, als wäre ein dreidimensionales metallisches Gebilde in dem Sicherheitselement enthalten.

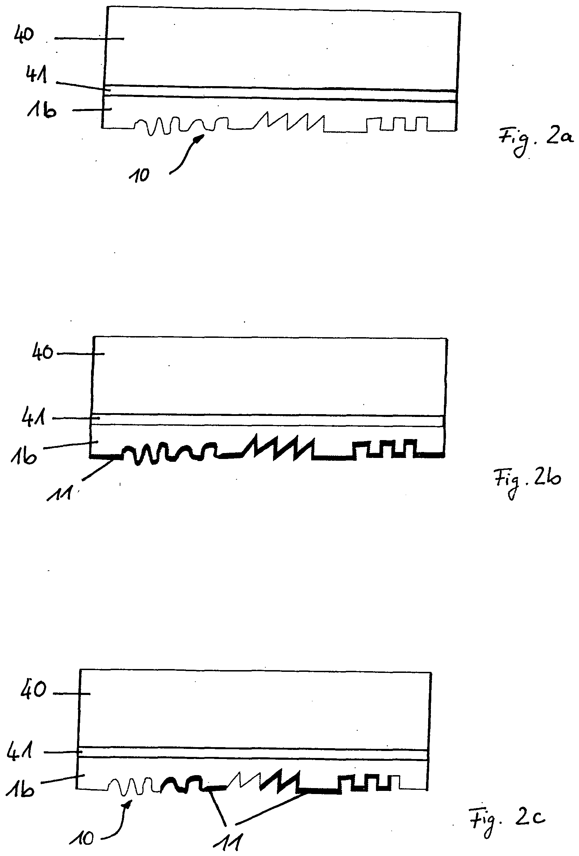

Die Figuren 2a bis 2i zeigen ein Verfahren zur Herstellung des Sicherheitselements 1 gemäß den Figuren 1 a und 1 b in vereinfachter Darstellung.

Gemäß Figur 2a ist auf einer Trägerfolie 40 eine Ablöseschicht 41 angeordnet, welche ein Ablösen eines nachfolgend darauf gebildeten Sicherheitselements 1 ermöglicht. Eine Trägerfolie weist üblicherweise eine Dicke im Bereich von 12 $\mu$m bis 100 $\mu$m auf. Auf die Ablöseschicht 41, die üblicherweise aus Wachs oder Silikon gebildet ist, wird eine transparente erste Replizierschicht 1 b in Form einer thermoplastischen Kunststoffschicht aufgebracht und mit einer diffraktiven Masterreliefstruktur 10 beprägt, indem ein hier nicht dargestelltes profiliertes Prägewerkzeug unter Druck und bei erhöhter Temperatur gegen die erste Replizierschicht 1 b gedrückt wird.

Gemäß Figur 2b wird auf die erste Replizierschicht 1 b eine erste Reflektionsschicht 11 aus Aluminium vollflächig aufgebracht und mit einer hier nicht dargestellten Photoresistschicht bedeckt. Durch eine musterförmige Belichtung der Photoresistschicht und deren partielle Entfernung wird die erste Reflektionsschicht 11 partiell freigelegt und von der ersten Replizierschicht 1 b durch Ätzen entfernt. Alternativ könnte aber auch eine ätzresistente Lackschicht musterförmig aufgedruckt werden, welche die erste Reflektionsschicht 11 in einem nachfolgenden Ätzprozess schützt.

Das Ergebnis zeigt sich in Figur 2c. Die erste Replizierschicht 1 b ist nun nur noch partiell mit der ersten Reflektionsschicht 11 bedeckt.
Gemäß Figur 2d wird nun die transparente Strukturschicht 1 a vollflächig auf der ersten Reflektionsschicht 11 und davon freien Bereichen der ersten Replizierschicht 1 b ausgebildet. Dabei wird auf der, der ersten Reflektionsschicht 11 zugewandten Seite der Strukturschicht 1 a die erste diffraktive Reliefstruktur 10a ausgebildet.

Gemäß Figur 2e wird die Strukturschicht 1 a nun auf ihrer, der ersten Reflektionsschicht 11 abgewandten Seite mit einer zweiten diffraktiven Reliefstruktur 10b beprägt und vollflächig mit einer zweiten Reflektionsschicht 12 aus Aluminium beschichtet. Die erste und die zweite Reliefstruktur 11, 12 sind unterschiedlich hinsichtlich ihrer Profilform, Orientierung oder Spatialfrequenzen.

Das Einbringen der zweiten Reliefstruktur kann unabhängig von der ersten Reliefstruktur erfolgen. Allerdings sollte zumindest in einer Richtung eine Ausrichtung bzw. Registrierung der zweiten Reliefstruktur hinsichtlich der ersten Reliefstruktur erfolgen, wobei eine Abweichung von der gewünschten Registrierung bzw. der Registerfehler < 2mm, insbesondere < 1 mm, betragen sollte.

Gemäß Figur 2f wird auf die zweite Reflektionsschicht 12 vollflächig eine Photoresistschicht 30 aufgebracht und musterförmig belichtet, wobei die Belichtung im Register zur bereichsweise ausgebildeten ersten Reflektionsschicht 11 erfolgt. Vorzugsweise wird die erste Reflektionsschicht 11 dabei als Belichtungsmaske für die Photoresistschicht 30 eingesetzt.

Alternativ kann die Photoresistschicht 30 auch musterförmig auf der ersten Reflektionsschicht 11 gebildet werden oder lediglich eine bereichsweise Belichtung, beispielsweise über eine elektronisch ansteuerbare Maske oder mittels eines Laserscanners, erfolgen, um individuelle Kennzeichnungen, beispielsweise in Form teiltransparenter im Durchlicht erkennbarer Bereiche, auszubilden.

Gemäß Figur 2g wird die Photoresistschicht 30 partiell entfernt und es verbleiben lediglich die Bereiche der Photoresistschicht 30 auf der zweiten Reflektionsschicht 12, die senkrecht zur Ebene der Strukturschicht 1 a gesehen deckungsgleich zur ersten Reflektionsschicht 11 angeordnet sind.

Gemäß Figur 2h werden nun die freigelegten Bereiche der zweiten Reflektionsschicht 12 durch Ätzen von der Strukturschicht 1 a entfernt.

Anschließend werden die Reste der Photoresistschicht 30 entfernt und vollflächig eine transparente Kleberschicht 20 auf die zweite Reflektionsschicht 12 und davon freie Bereiche der Strukturschicht 1 a aufgebracht. Es liegt nun eine Transferfolie 200 mit der Trägerfolie 40, der Ablöseschicht 41 und dem Sicherheitselement 1 vor, das mittels Prägens auf ein Sicherheitsdokument appliziert und mittels der Kleberschicht 20 darauf befestigt werden kann. Die Trägerfolie 40 und die Ablöseschicht 41 werden anschließend vom Sicherheitselement 1 abgezogen. Sofern es sich um eine transparente Ablöseschicht 41 handelt, kann diese auch auf dem Sicherheitselement 1 verbleiben, so dass lediglich die Trägerfolie 40 entfernt wird. Am Sicherheitselement 1 sind in der Durchsicht nun transparente Bildelemente 100b neben opaken Bildelementen 100a, 100c erkennbar.

Alternativ kann auch ohne eine Ablöseschicht 41 gearbeitet werden, wenn die Trägerfolie 40 sich problemlos von der ersten Replizierschicht 1 b ablösen lässt.

Wird das Sicherheitselement als Laminierfolie ausgeführt, so ist dieses aufgrund seiner höheren Dicke sehr stabil und zudem selbsttragend. Laminierfolien eignen sich insbesondere, um Fensteröffnungen in Sicherheitsdokumenten zuverlässig und dauerhaft abzudecken bzw. zu überspannen. Es können dabei Trägerfolien bis zu einigen 100 $\mu$m Dicke zum Aufbau des Sicherheitselements verwendet werden und gleichzeitig der Abstand zwischen der ersten und zweiten Reflektionsschicht kleiner 15 $\mu$m gehalten bzw. minimiert werden.

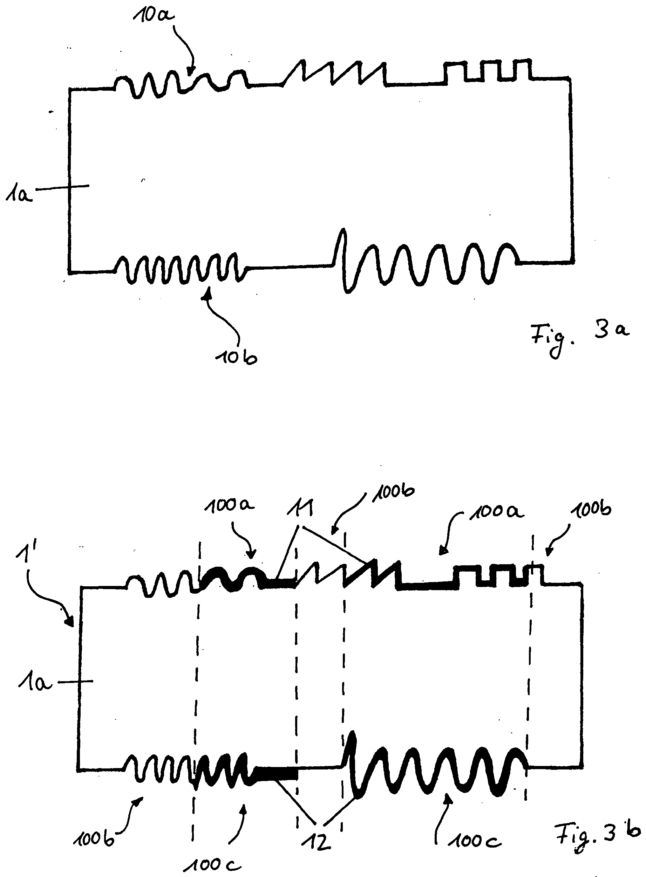

Figur 3a zeigt eine selbsttragende thermoplastische transparente Strukturschicht 1 a mit einer geprägten diffraktiven ersten Reliefstruktur 10a und einer diffraktiven zweiten Reliefstruktur 10b, wobei sich die erste Reliefstruktur 10a und die zweite Reliefstruktur 10b unterscheiden.

Figur 3b zeigt ein Sicherheitselement 1' mit einer Strukturschicht 1 a gemäß Figur 3a. Die erste Reliefstruktur 10a ist angrenzend an eine bereichsweise ausgebildete erste Reflektionsschicht 11 aus Gold angeordnet, während die zweite Reliefstruktur 10b angrenzend an eine bereichsweise und deckungsgleich zur ersten Reflektionsschicht 11 ausgebildete zweite Reflektionsschicht 12 aus Silber angeordnet ist. Wird das Sicherheitselement 1' von der Seite betrachtet, auf der sich die erste Reflektionsschicht 11 befindet, so zeigt sich ein Bildmotiv mit goldenen metallisch spiegelnden opaken Bildelementen 100a und transparenten Bildelementen 100b. Im Bereich der opaken Bildelemente 100a wird eine erste Information vermittelt, die durch die erste Reliefstruktur 10a generiert wird. Wird das Sicherheitselement 1' von der Seite betrachtet, auf der sich die zweite Reflektionsschicht 12 befindet, so zeigt sich das Bildmotiv in der Rückansicht mit silbernen metallisch spiegelnden opaken Bildelementen 100c und transparenten Bildelementen 100b. Im Bereich der opaken Bildelemente 100c wird eine zweite Information vermittelt, die durch die zweite Reliefstruktur 10b generiert wird.

Bei Verwendung von gleichen Materialien, wie beispielsweise Aluminium, zur Bildung der ersten und zweiten Reflektionsschicht, können unterschiedliche farbeffekte auch dadurch erzeugt werden, dass eine oder beide Reflektionsschichten mit einer transparenten farbigen Schicht bedeckt werden. Wird sowohl die erste als auch die zweite Reflektionsschicht jeweils auf ihrer dem Betrachter zugewandten Seite mit einer derartigen Schicht bedeckt, können diese beiden Schichten eine gleiche oder eine unterschiedliche Einfärbung aufweisen. Eine einzelne transparente farbige Schicht kann auch bereichsweise oder musterförmig, gegebenenfalls auch mit unterschiedlichen Farben, eingefärbt sein.

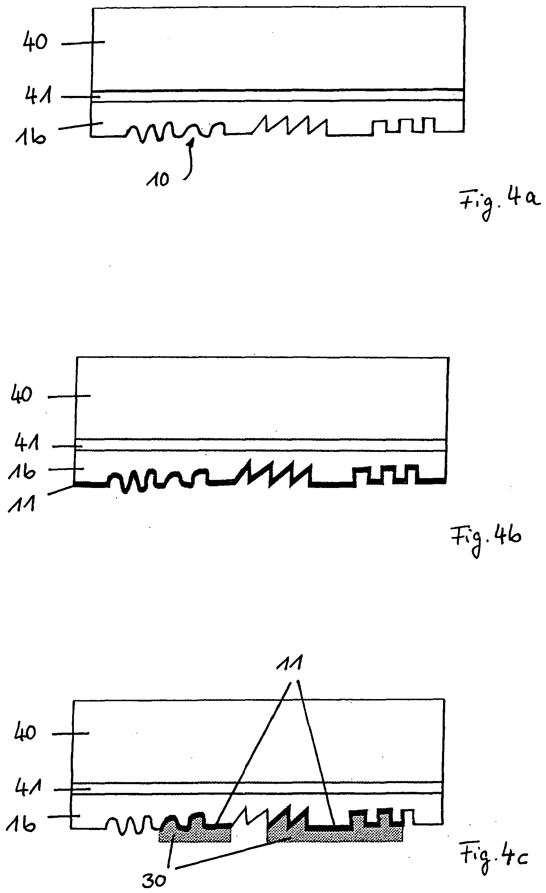

Die Figuren 4a bis 4g zeigen ein weiteres Verfahren zur Herstellung eines Sicherheitselements mit einer ersten opaken Hilfsschicht in Form einer opak eingefärbten Photoresistschicht 30 im Querschnitt.

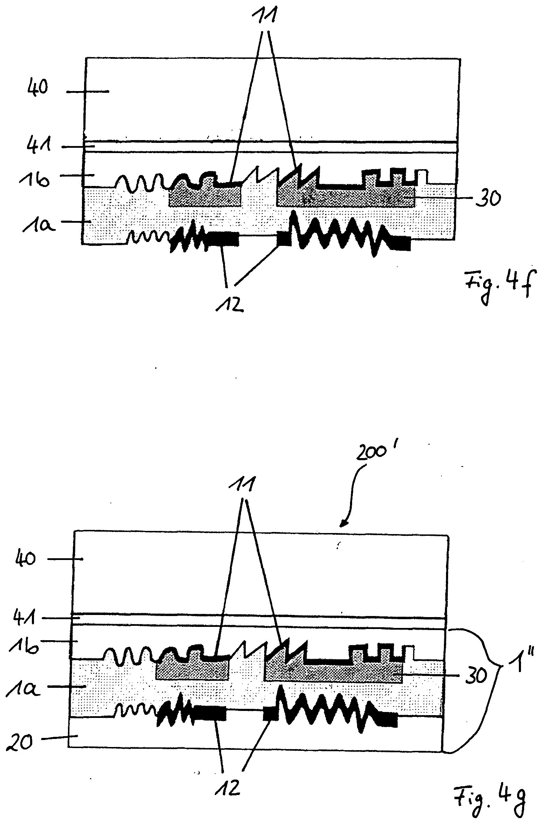

Gemäß Figur 4a ist eine Trägerfolie 40 aus PET vorhanden, die vom darauf zu bildenden Sicherheitselement 1" (siehe Figur 4g) ablösbar ist. Auf der Trägerfolie 40 sind eine Ablöseschicht 41 und eine transparente erste Replizierschicht 1 b angeordnet, die auf ihrer der Ablöseschicht 41 abgewandten Seite mit einer diffraktiven ersten Reliefstruktur 10a beprägt ist.

Gemäß Figur 4b wird auf die erste Replizierschicht 1 b vollflächig eine transparente erste Reflektionsschicht 11 aus ZnS aufgebracht und darauf vollflächig eine opak grün eingefärbte Photoresistschicht 30 gebildet, diese musterförmig belichtet und bereichsweise entfernt. Die farbige Photoresistschicht 30 wird insbesondere in einer so hohen Schichtdicke ausgebildet, so dass auf ihrer, der ersten Replizierschicht 1 b abgewandten Seite keinerlei Reliefstruktur mehr vorliegt. Es schließt sich ein Ätzprozess an, bei welchem die erste Reflektionsschicht 11 in den Bereichen entfernt wird, welche nicht von der musterförmigen Photoresistschicht 30, die eine erste opake Hilfsschicht bildet, bedeckt und geschützt sind.

Das Ergebnis dieser Verfahrensschritte ist gemäß Figur 4c dargestellt. Die erste Reflektionsschicht 11 liegt nun musterförmig strukturiert und deckungsgleich mit der musterförmigen farbigen Photoresistschicht 30 bzw. der opaken Hilfsschicht vor. Alternativ zur beschriebenen Verwendung einer Photoresistschicht kann die opake Hilfsschicht auch ausgebildet werden, indem diese musterförmig aufgedruckt wird.

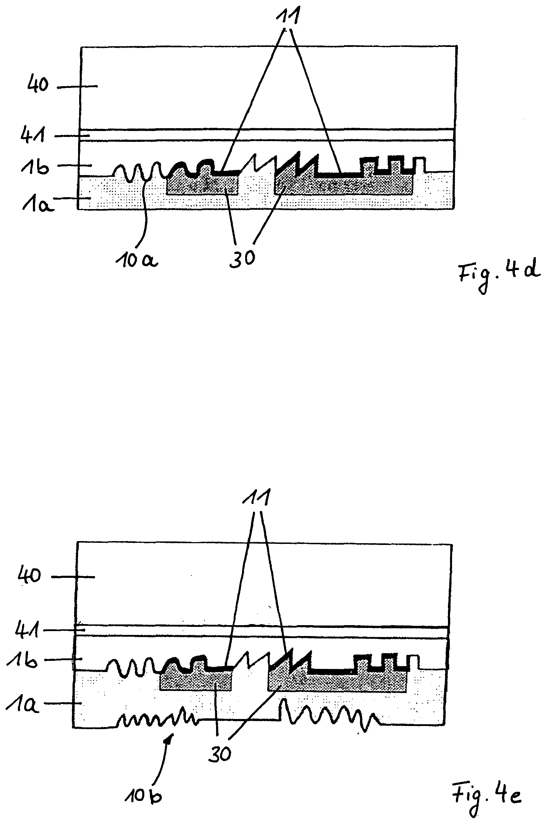

Gemäß Figur 4d wird nun vollflächig eine transparente Strukturschicht 1a gebildet, welche die Photoresistschicht 30 und davon freie Bereiche der ersten Replizierschicht 1 b bedeckt.

Wie in Figur 4e dargestellt, wird die Strukturschicht 1 a mit einer diffraktiven zweiten Reliefstruktur 10b beprägt, welche sich von der ersten Reliefstruktur 10a unterscheidet.

Auf die Strukturschicht 1 a mit der zweiten Reliefstruktur 10b wird nun vollflächig eine transparente zweite Reflektionsschicht 12 aus ZnS aufgebracht. Die zweite Reflektionsschicht 12 wird auf ihrer der Strukturschicht 1 a abgewandten Seite mit einer weiteren Photoresistschicht bedeckt und diese musterförmig belichtet, wobei die opake Hilfsschicht als Belichtungsmaske fungiert. Die weitere Photoresistschicht wird bereichsweise entfernt, die zweite Reflektionsschicht 12 entsprechend freigelegt und die freigelegten Bereiche anschließend durch Ätzen entfernt. Nach Entfernen der Reste der weiteren Photoresistschicht liegt eine Anordnung vor, wie in Figur 4f gezeigt.

Gemäß Figur 4g liegt nun eine Transferfolie 200' vor, die das Sicherheitselement 1" und die davon ablösbare Trägerfolie 40 beinhaltet. Gegebenenfalls kann auf der, der Trägerfolie 40 abgewandten Seite des Sicherheitselements 1" eine Kleberschicht 20 angeordnet sein, um das Sicherheitselement 1" auf ein Sicherheitsdokument mittels Heißzuprägens zu applizieren.

Wird das gebildete Sicherheitselement 1" so betrachtet, dass die erste Reflektionsschicht 11 dem Betrachter zugewandt ist, so zeigt sich die erste Information, welche durch die erste Reliefstruktur 10a im Zusammenspiel mit der ersten Reflektionsschicht 11 generiert wird, vor der musterförmigen opak grün eingefärbten Photoresistschicht 30 bzw. der ersten opaken Hilfsschicht. Die optisch variablen Effekte, die von der zweiten Reliefstruktur 10b im Zusammenspiel mit der zweiten Reflektionsschicht 12 gebildet werden, sind durch die erste opake Hilfsschicht vollständig verdeckt. Wird das gebildete Sicherheitselement 1" so betrachtet, dass die zweite Reflektionsschicht 12 dem Betrachter zugewandt ist, so zeigt sich die zweite Information, welche durch die zweite Reliefstruktur 10b im Zusammenspiel mit der zweiten Reflektionsschicht 12 generiert wird vor der musterförmigen opak grün eingefärbten Photoresistschicht 30 bzw. ersten opaken Hilfsschicht. Die optisch variablen Effekte der ersten Reliefstruktur 10a, die durch die erste Reliefstruktur 10a im Zusammenspiel mit der ersten Reflektionsschicht 11 ausgebildet werden, werden durch die erste opake Hilfsschicht vollständig verdeckt. Bei geeigneter Positionierung der ersten und zweiten Reflektionsschicht, der mindestens einen opaken Hilfsschicht sowie der ersten und zweiten Reliefstrukturen zueinander können demnach besonders schwer nachahmbare, hochwertige und ansprechende Sicherheitselemente ausgebildet werden.

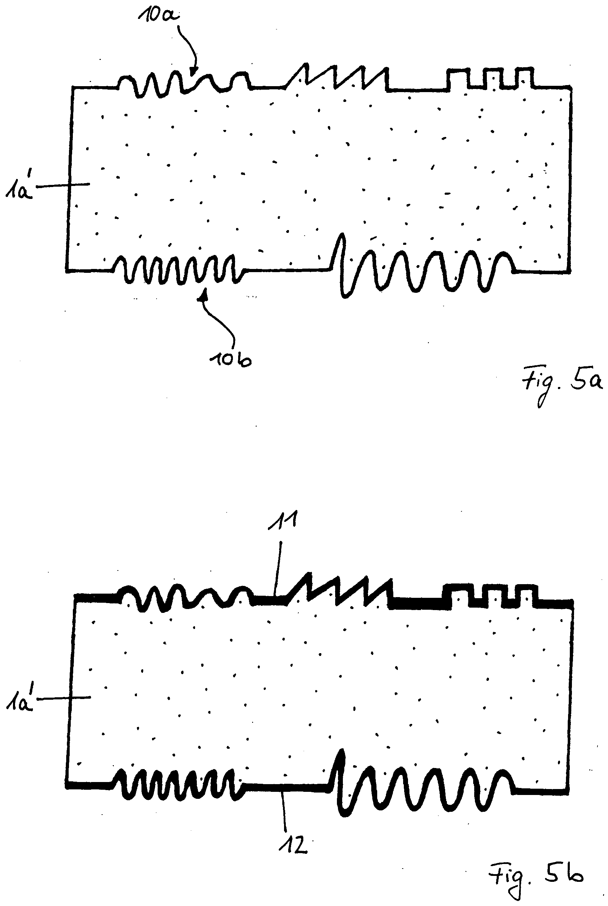

Figuren 5a bis 5d zeigen ein weiteres Verfahren zur Herstellung eines Sicherheitselements mit einer ersten opaken Hilfsschicht in Form einer partiell opak eingefärbten Strukturschicht im Querschnitt.

Gemäß Figur 5a ist eine selbsttragende transparente Strukturschicht 1a' vorhanden, die ein transparentes Farbmittel enthält, welches bei Bestrahlung opak farbig oder schwarz wird. Die Strukturschicht 1a' ist auf einer ersten Seite mit einer diffraktiven ersten Reliefstruktur 10a und auf ihrer zweiten Seite mit einer diffraktiven zweiten Reliefstruktur 10b beprägt.

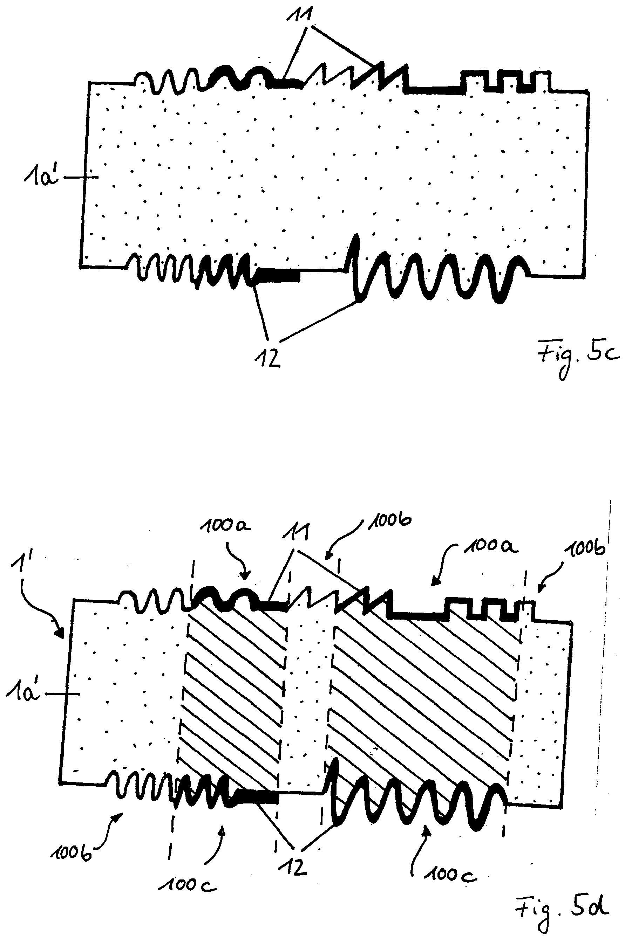

Auf die Strukturschicht 1 a' wird beidseitig vollflächig jeweils eine transparente Reflektionsschicht 11, 12 aus ZnS aufgebracht (siehe Figur 5b). Darauf wird beidseitig musterförmig eine Ätzpaste aufgebracht, welche die darunter liegenden Bereiche der jeweiligen Reflektionsschicht 11, 12 auflöst bzw. bereichsweise entfernt. Das Ergebnis dieser Verfahrensschritte ist gemäß Figur 5c dargestellt. Die erste Reflektionsschicht 11 liegt nun musterförmig strukturiert und deckungsgleich zur musterförmig strukturierten zweiten Reflektionsschicht 12 vor.

Die transparente Strukturschicht 1a' wird nun musterförmig, beispielsweise über eine Maske, belichtet. Das transparente Farbmittel in der Strukturschicht 1 a' wird in den Bereichen 100a, 100c bestrahlt und wird dadurch farbig, so dass die Strukturschicht 1a' nach der Belichtung in den Bereichen 100a, 100c opak erscheint und eine erste opake Hilfsschicht ausbildet. Die Bereiche 100b der Strukturschicht 1a'verbleiben dagegen transparent. Gemäß Figur 5d liegt nun ein Sicherheitselement 1' vor, das beispielsweise mittels einer Kleberschicht auf ein Sicherheitsdokument appliziert werden kann.

Wird das gebildete Sicherheitselement 1' so betrachtet, dass die erste Reflektionsschicht 11 dem Betrachter zugewandt ist, so zeigt sich die erste Information, welche durch die erste Reliefstruktur 10a im Zusammenspiel mit der transparenten ersten Reflektionsschicht 11 generiert wird, vor opak eingefärbten Bereichen der Strukturschicht 1 a' bzw. der ersten opaken Hilfsschicht. Die optisch variablen Effekte, die von der zweiten Reliefstruktur 10b im Zusammenspiel mit der zweiten Reflektionsschicht 12 gebildet werden, sind durch die erste opake Hilfsschicht vollständig verdeckt. Wird das gebildete Sicherheitselement 1' so betrachtet, dass die zweite Reflektionsschicht 12 dem Betrachter zugewandt ist, so zeigt sich die zweite Information, welche durch die zweite Reliefstruktur 10b im Zusammenspiel mit der transparenten zweiten Reflektionsschicht 12 generiert wird vor der musterförmig opak eingefärbten Strukturschicht 1 a' bzw. der ersten opaken Hilfsschicht. Die optisch variablen Effekte der ersten Reliefstruktur 10a, die durch die erste Reliefstruktur 10a im Zusammenspiel mit der ersten Reflektionsschicht 11 ausgebildet werden, werden durch die erste opake Hilfsschicht vollständig verdeckt.

Bei geeigneter Positionierung der ersten und zweiten Reflektionsschicht, der mindestens einen opaken Hilfsschicht sowie der ersten und zweiten Reliefstrukturen zueinander können demnach besonders schwer nachahmbare, hochwertige und ansprechende Sicherheitselemente ausgebildet werden.

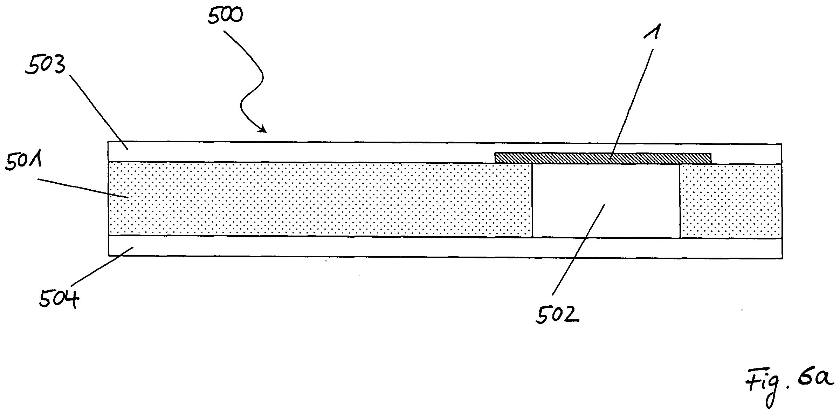

Figur 6a zeigt ein Sicherheitsdokument 500 mit einem erfindungsgemäßen Sicherheitselement 1 in Querschnitt. Das Sicherheitsdokument 500 weist ein Trägersubstrat 501 aus Papier mit einer Fensteröffnung 502 als transparentem Bereich auf. Das Sicherheitselement 1 überspannt hier die Fensteröffnung 502 oder ist alternativ in der Fensteröffnung angeordnet, beispielsweise zwischen zwei Papierlagen des Trägersubstrats 501. Das Sicherheitsdokument 500 weist weiterhin optional zwei farblos transparente Schutzschichten 503, 504 auf, welche das Trägersubstrat 501 und das Sicherheitselement 1 zwischen sich einschließen und vor mechanischer Beanspruchung und Feuchtigkeit schützen. Das Sicherheitselement 1 kann somit von beiden Seiten im transparenten Bereich des Sicherheitsdokuments 500 betrachtet werden.

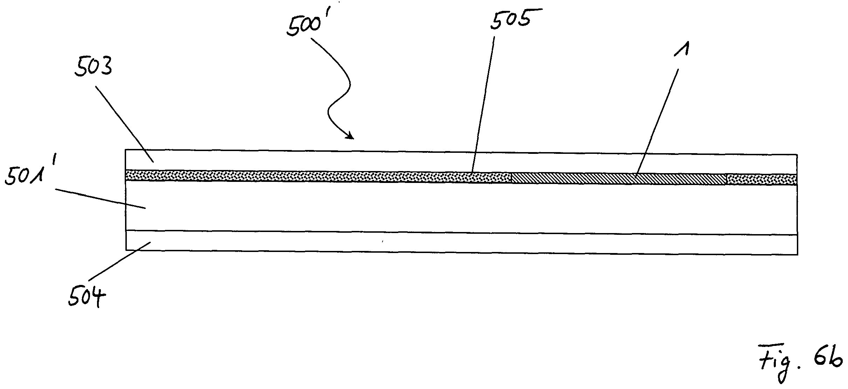

Figur 6b zeigt ein weiteres Sicherheitsdokument 500' mit einem erfindungsgemäßen Sicherheitselement 1 in Querschnitt. Das Sicherheitsdokument 500' weist ein transparentes Trägersubstrat 501', beispielsweise aus PET, PVC oder PC, sowie eine opake Druckfarbenschicht 505 auf. Das Sicherheitselement 1 ist auf das Trägersubstrat 501' appliziert, oder alternativ in dieses einlaminiert, und von der opaken Druckfarbenschicht 505 umgeben. Das Sicherheitselement 1 könnte dabei auch teilweise überlappend zur opaken Druckfarbenschicht 505 angeordnet werden. Das Sicherheitselement 1 kann weitgehend aus demselben Material gebildet sein wie das Trägersubstrat 501'. Das Sicherheitsdokument 500' weist weiterhin optional zwei farblos transparente Schutzschichten 503, 504 auf, welche das Trägersubstrat 501', die Druckfarbenschicht 505 und das Sicherheitselement 1 zwischen sich einschließen und vor mechanischer Beanspruchung und Feuchtigkeit schützen. Das Sicherheitselement 1 kann somit von beiden Seiten im transparenten Bereich des Sicherheitsdokuments 500' betrachtet werden.

**Patentansprüche**

1. Sicherheitselement (1, 1', 1") mit mindestens einer, zumindest bereichsweise transparenten Strukturschicht (1a, 1a'), mit einer zumindest bereichsweise angeordneten diffraktiven ersten Reliefstruktur (10a) und einer zumindest bereichsweise angeordneten diffraktiven zweiten Reliefstruktur (10b), wobei die erste und die zweite Reliefstruktur (10a, 10b) sich zumindest bereichsweise unterscheiden und parallel zur Ebene der Strukturschicht (1a, 1a') gesehen in unterschiedlichen Ebenen des Sicherheitselements (1, 1', 1") angeordnet sind, wobei die erste Reliefstruktur (10a) an eine erste Reflektionsschicht (11) mit einem ersten Umriss angrenzt und die zweite Reliefstruktur (10b) an eine zweite Reflektionsschicht (12) mit einem zweiten Umriss angrenzt, wobei die erste Reflektionsschicht (11) und die zweite Reflektionsschicht (12) senkrecht zur Ebene der Strukturschicht (1a, 1a') gesehen bereichsweise ausgebildet sind und zumindest bereichsweise überlappen, wobei zumindest Teilbereiche des ersten und zweiten Umrisses senkrecht zur Ebene der Strukturschicht (1 a, 1 a') gesehen deckungsgleich zueinander und angrenzend an mindestens einen transparenten Bereich der Strukturschicht (1 a, 1 a') verlaufen und der mittlere Abstand zwischen der ersten und der zweiten Reflektionsschicht weniger als 15 $\mu$m beträgt und wobei - sofern die erste Reflektionsschicht (11) einem Betrachter zugewandt ist - eine durch die zweite Reliefstruktur (10b) im Bereich der Überlappung generierte zweite Information (51) zumindest teilweise verdeckt ist und - sofern die zweite Reflektionsschicht (12) dem Betrachter zugewandt ist - eine von der ersten Reliefstruktur (10a) im Bereich der Überlappung generierte erste Information (50) zumindest teilweise verdeckt ist.

2. Sicherheitselement nach Anspruch 1,
   **dadurch gekennzeichnet,**
   **dass** die erste und die zweite Information (50, 51) sich zumindest bereichsweise voneinander unterscheiden.

3. Sicherheitselement nach einem der Ansprüche 1 bis 2,
   **dadurch gekennzeichnet,**

**dass** die Strukturschicht (1a, 1a') auf einer ersten Seite die diffraktive erste Reliefstruktur (10a) und auf einer zweiten Seite die diffraktive zweite Reliefstruktur (10b) aufweist, wobei die erste Seite an die erste Reflektionsschicht (11) angrenzt und die zweite Seite an die zweite Reflektionsschicht (12) angrenzt.

4. Sicherheitselement nach einem der Ansprüche 1 bis 3,
   **dadurch gekennzeichnet,**
   **dass** die erste und die zweite Reflektionsschicht (11, 12) senkrecht zur Ebene der Strukturschicht (1 a, 1 a') gesehen überwiegend oder vollständig deckungsgleich zueinander ausgebildet sind.

5. Sicherheitselement nach den Ansprüchen 1 bis 4,
   **dadurch gekennzeichnet,**
   **dass** die erste und die zweite Reflektionsschicht (11, 12) sich in Material und/oder Farbe unterscheiden.

6. Sicherheitselement nach einem der Ansprüche 1 bis 5,
   **dadurch gekennzeichnet,**
   **dass** die Strukturschicht (1a, 1a') eine Schichtdicke im Bereich von 0,2 bis 15 $\mu$m, insbesondere im Bereich von 0,3 bis 3 $\mu$m aufweist.

7. Sicherheitselement nach einem der Ansprüche 1 bis 6,
   **dadurch gekennzeichnet,**
   **dass** das Sicherheitselement im Durchlicht gesehen im Bereich mindestens einer der Reflektionsschichten (11, 12) sichtbar unterschiedlich transmissive Bereiche aufweist, die eine weitere Information zeigen.

8. Sicherheitsdokument mit mindestens einem Sicherheitselement (1, 1', 1 ") nach einem der Ansprüche 1 bis 7,
   **dadurch gekennzeichnet,**
   **dass** das mindestens eine Sicherheitselement (1, 1', 1") in mindestens einem transparenten Bereich des Sicherheitsdokuments (500, 500') oder teilweise überlappend mit diesem angeordnet ist.

9. Verfahren zur Herstellung eines Sicherheitselements (1) nach einem der Ansprüche 1 bis 7, **gekennzeichnet durch** folgende Schritte:

   a) Bereitstellen einer transparenten ersten Replizierschicht (1 b);
   b) Bilden einer diffraktiven Masterreliefstruktur (10) auf einer ersten Oberfläche der ersten Replizierschicht (1 b);
   c) Bilden der bereichsweise ausgebildeten ersten Reflektionsschicht (11), gegebenenfalls weiterhin mindestens einer bereichsweise ausgebildeten ersten opaken Hilfsschicht auf der ersten Oberfläche;
   d) Bilden der zumindest bereichsweise transparenten Strukturschicht (1 a) durch eine zweite Replizierschicht, welche auf der ersten Reflektionsschicht (11) und gegebenenfalls der mindestens einen ersten opaken Hilfsschicht und davon freien Bereichen der ersten Oberfläche angeordnet wird;
   e) Bilden der diffraktiven zweiten Reliefstruktur (10b) auf einer zweiten Seite der Strukturschicht (1 a); und
   f) Bilden der bereichsweise ausgebildeten zweiten Reflektionsschicht (12) auf der zweiten Seite der Strukturschicht (1a) in einer Schichtdicke, bei der die zweite Reliefstruktur (10b) auf der, der Strukturschicht (1 a) abgewandten Seite der zweiten Reflektionsschicht (12) abgeformt wird, wobei der mittlere Abstand zwischen der ersten und der zweiten Reflektionsschicht weniger als 15 $\mu$m beträgt.

10. Verfahren nach Anspruch 9,
    **dadurch gekennzeichnet,**
    **dass** die erste und/oder die zweite Reflektionsschicht transparent ausgebildet wird und senkrecht zur Ebene der Strukturschicht gesehen mindestens eine opake Hilfsschicht deckungsgleich zu der/den transparenten Reflektionsschicht(en) angeordnet wird.

11. Verfahren zur Herstellung eines Sicherheitselements (1') nach einem der Ansprüche 1 bis 7, **gekennzeichnet durch** folgende Schritte:

    g) Bereitstellen einer transparenten Strukturschicht (1a, 1a');
    h) Bilden der diffraktiven ersten Reliefstruktur (10a) auf einer ersten Seite und der diffraktiven zweiten Reliefstruktur (10b) auf einer zweiten Seite der Strukturschicht (1a, 1a');
    i) Bilden der zumindest bereichsweise ausgebildeten ersten Reflektionsschicht (11) und gegebenenfalls mindestens einer ersten opaken Hilfsschicht auf der ersten Seite der Strukturschicht (1a, 1a'); und

k) Bilden der zumindest bereichsweise ausgebildeten zweiten Reflektionsschicht (12) und gegebenenfalls mindestens einer zweiten opaken Hilfsschicht auf der zweiten Seite der Strukturschicht (1 a, 1 a'), wobei der mittlere Abstand zwischen der ersten und der zweiten Reflektionsschicht weniger als 15 $\mu$m beträgt.

**12.** Verfahren nach Anspruch 9, 10 oder 11,
**dadurch gekennzeichnet,**
**dass** die mindestens eine opake Hilfsschicht gebildet wird, indem die Strukturschicht bereichsweise belichtet wird und ein in der Strukturschicht enthaltenes transparentes Farbmittel in den belichteten Bereichen in ein opakes, farbiges Farbmittel umgewandelt wird.

**13.** Verfahren nach Anspruch 11,
**dadurch gekennzeichnet,**
**dass** die erste und die zweite Reliefstruktur (10a, 10b) gleichzeitig durch Prägen gebildet werden.

**14.** Verfahren nach einem der Ansprüche 9 bis 13,
**dadurch gekennzeichnet,**
**dass** in Schritt c) oder Schritt i) die erste Reflektionsschicht (11) vollflächig aufgebracht wird, dass auf die erste Reflektionsschicht (11) vollflächig eine erste Photoresistschicht aufgebracht wird, dass die erste Photoresistschicht partiell belichtet und entfernt wird, wobei insbesondere die Belichtung der ersten Photoresistschicht durch die erste Reflektionsschicht (11) hindurch erfolgt, wobei die partielle Belichtung der ersten Photoresistschicht in Abhängigkeit von der Ausgestaltung und/oder Anordnung der ersten Reliefstruktur (10a) erfolgt, dass die erste Reflektionsschicht (11) in den Bereichen durch Ätzen entfernt wird, in denen die erste Photoresistschicht entfernt wurde, und dass gegebenenfalls die verbliebenen Bereiche der ersten Photoresistschicht entfernt werden oder als eine erste opake Hilfsschicht verwendet werden.

**15.** Verfahren nach einem der Ansprüche 9 bis 14,
**dadurch gekennzeichnet,**
**dass** in Schritt f) oder Schritt k) die zweite Reflektionsschicht (12) vollflächig aufgebracht wird, dass auf die zweite Reflektionsschicht (12) vollflächig eine zweite Photoresistschicht aufgebracht wird, dass die zweite Photoresistschicht partiell belichtet und entfernt wird, wobei insbesondere die Belichtung der ersten Photoresistschicht durch die erste und die zweite Reflektionsschicht (11, 12) hindurch erfolgt, wobei die partielle Belichtung der ersten Photoresistschicht in Abhängigkeit von der Ausgestaltung und/oder Anordnung der ersten Reliefstruktur (10a) erfolgt, dass die zweite Reflektionsschicht (12) in den Bereichen durch Ätzen entfernt wird, in denen die zweite Photoresistschicht entfernt wurde, und dass gegebenenfalls die verbliebenen Bereiche der zweiten Photoresistschicht entfernt werden.

## Claims

**1.** Security element (1, 1', 1") having at least one at least regionally transparent structural layer (1a, 1a'), having an at least regionally arranged diffractive first relief structure (10a) and an at least regionally arranged diffractive second relief structure (10b), wherein the first and the second relief structures (10a, 10b) differ at least regionally and are arranged into different levels of the security element (1, 1', 1") from the perspective parallel to the level of the structural level (1a, 1a'), wherein the first relief structure (10a) is adjacent to a first reflection layer (11) with a first contour and the second relief structure (10b) is adjacent to a second reflection layer (12) with a second contour, wherein the first reflection layer (11) and the second reflection layer (12) are formed regionally from the perspective perpendicular to the level of the structural layer (1a, 1a') and overlap at least regionally, wherein at least partial regions of the first and second contours run congruently with each other from the perspective perpendicular to the level of the structural layer (1a, 1a') and adjacent to at least one transparent region of the structural layer (1a, 1a') and the average distance between the first and the second reflection layers is less than 15 $\mu$m and wherein -provided the first reflection layer (11) is facing an observer -a second piece of information (51) generated in the region of the overlap by the second relief structure (10b) is at least partially covered and - provided the second reflection layer (12) is facing the observer - a first piece of information (50) generated in the region of the overlap by the first relief structure (10a) is at least partially covered.

**2.** Security element according to claim 1,
**characterised in that**
the first and the second piece of information (50, 51) differ from each other at least

regionally.

3. Security element according to one of claims 1 to 2,
**characterised in that**
the structural layer (1a, 1a') has the diffractive first relief structure (10a) on a first side and the diffractive second relief structure (10b) on a second side, wherein the first side is adjacent to the first reflection layer (11) and the second side is adjacent to the second reflection layer (12).

4. Security element according to one of claims 1 to 3,
**characterised in that**
the first and the second reflection layers (11, 12) are formed to be predominantly or completely congruent with each other from the perspective perpendicular to the level of the structural layer (1a, 1a').

5. Security element according to claims 1 to 4,
**characterised in that**
the first and the second reflection layer (11, 12) differ in terms of material and/or colour.

6. Security element according to one of claims 1 to 5,
**characterised in that**
the structural layer (1a, 1a') has a thickness in the range from 0.2 to 15 $\mu$m, in particular in the range from 0.3 to 3 $\mu$m.

7. Security element according to one of claims 1 to 6,
**characterised in that**
the security element seen in transmitted light has visibly differenttransmissive regions in the region of at least one of the reflection layers (11, 12), said regions showing a further piece of information.

8. Security document having at least one security element (1, 1', 1") according to one of claims 1 to 7,
**characterised in that**
the at least one security element (1, 1', 1") is arranged in at least one transparent region of the security document (500, 500') or such that it partially overlaps this.

9. Method for producing a security element (1) according to one of claims 1 to 7, **characterised by** the following steps:

a) providing a transparent first replicate layer (1b);
b) forming a diffractive master relief structure (10) on a first surface of the first replicate layer (1b);
c) forming the regionally formed first reflection layer (11), where applicable also at least one regionally formed first opaque auxiliary layer on the first surface;
d) forming the at least regionally transparent structural layer (1a) by a second replicate layer which is arranged on the first reflection layer (11) and, where applicable, the at least one first opaque auxiliary layer and the regions free of this of the first surface;
e) forming the diffractive second relief structure (10b) on a second side of the structural layer (1a); and
f) forming the regionally formed second reflection layer (12) on the second side of the structural layer (1a) at a thickness in which the second relief structure (10b) is cast on the side of the second reflection layer (12) facing away from the structural layer (1a),wherein the average distance between the first and the second reflection layer is less than 15 $\mu$m.

10. Method according to claim 9,
**characterised in that**
the first and/or the second reflection layers are formed to be transparent and,from the perspective perpendicular to the level of the structural layer, at least one opaque auxiliary layer is arranged congruently with the transparent reflection layer(s).

11. Method for producing a security element (1') according to one of claims 1 to 7,
**characterised by** the following steps:

g) providing a transparent structural layer (1a, 1a');
h) forming the diffractive first relief structure (10a) on a first side and the diffractive second relief structure (10b) on a second side of the structural layer (1a, 1a');

i) forming the at least regionally formed first reflection layer (11) and, where applicable, at least onefirst opaque auxiliary layer on the first side of the structural layer (1a, 1a'); and

k) forming the at least regionally formed second reflection layer (12) and, where applicable, at least one second opaque auxiliary layer on the second side of the structural layer (1a, 1a'), wherein the average distance between the first and the second reflection layer is less than 15 $\mu$m.

12. Method according to claim 9, 10 or 11,
**characterised in that**
the at least one opaque auxiliary layer is formed by the structural layer being regionally exposed and a transparent colourant contained in the structural layer being converted into an opaque, coloured colourant in the exposed regions.

13. Method according to claim 11,
**characterised in that**
the first and the second relief structures (10a, 10b) are formed at the same time by embossing.

14. Method according to one of claims 9 to 13,
**characterised in that**,
in step c) or step i), the first reflection layer (11) is applied allover, a first photo-resistant layer is applied allover on the first reflection layer (11), the first photo-resistant layer is partially exposed and removed, wherein, in particular, the exposure of the first photo-resistant layer takes place through the first reflection layer (11), wherein the partial exposure of the first photo-resistant layer takes place depending on the design and/or arrangement of the first relief structure (10a), the first reflection layer (11) is removed by etching in the regions in which the first photo-resistant layer was removed, and, where applicable, the remaining regions of the first photo-resistant layer are removed or used as a first opaque auxiliary layer.

15. Method according to one of claims 9 to 14,
**characterised in that**,
in step f) or step k), the second reflection layer (12) is applied allover, a second photo-resistant layer is applied allover on the second reflection layer (12), the second photo-resistant layer is partially exposed and removed, wherein, in particular, the exposure of the first photo-resistant layer takes place through the first and the second reflection layers (11, 12), wherein the partial exposure of the first photo-resistant layer takes place depending on the design and/or arrangement of the first relief structure (10a), the second reflection layer (12) is removed by etching in the regions in which the second photo-resistant layer was removed, and, where applicable, the remaining regions of the second photo-resistant layer are removed.

**Revendications**

1. Elément de sécurité (1, 1', 1") comprenant au moins une couche de structure (1a, 1a') au moins par endroits transparente, comprenant une première structure en relief (10a) diffractive disposée au moins par endroits et une deuxième structure en relief (10b) diffractive disposée au moins par endroits, dans lequel la première et la deuxième structure en relief (10a, 10b) se distinguent au moins par endroits et sont disposées, vues de manière parallèle par rapport au plan de la couche de structure (1a, la'), dans différents plans de l'élément de sécurité (1, 1', 1"), dans lequel la première structure en relief (10a) jouxte une première couche réfléchissante (11) présentant un premier contour et la deuxième structure en relief (10b) jouxte une deuxième couche réfléchissante (12) présentant un deuxième contour, dans lequel la première couche réfléchissante (11) et la deuxième couche réfléchissante (12) sont réalisées par endroits vues de manière perpendiculaire par rapport au plan de la couche de structure (la,la') et se chevauchent au moins par endroits, dans lequel au moins des zones partielles du premier et du deuxième contour s'étendent, vues de manière perpendiculaire par rapport au plan de la couche de structure (1a, 1a'), de manière à coïncider et de manière à jouxter au moins une zone transparente de la couche de structure (1a, 1a') et la distance moyenne entre la première et la deuxième couche réfléchissante est inférieure à 15 $\mu$m, et dans lequel, dans la mesure où la première couche réfléchissante (11) est tournée vers un observateur, une deuxième information (51) générée par la deuxième structure en relief (10b) dans la zone du chevauchement est dissimulée au moins en partie et, dans la mesure où la deuxième couche réfléchissante (12) est tournée vers l'observateur, une première information (50) générée par la première structure en relief (10a) dans la zone du chevauchement est dissimulée au moins en partie.

2. Elément de sécurité selon la revendication 1,

**caractérisé en ce**
**que** la première et la deuxième information (50, 51) se distinguent au moins par endroits.

3. Elément de sécurité selon l'une quelconque des revendications 1 à 2,
**caractérisé en ce**
**que** la couche de structure (1a, 1a') présente sur un premier côté la première structure en relief (10a) diffractive et, sur un second côté, la deuxième structure en relief (10b) diffractive, dans lequel le premier côté jouxte la première couche réfléchissante (11) et le second côté jouxte la deuxième couche réfléchissante (12).

4. Elément de sécurité selon l'une quelconque des revendications 1 à 3,
**caractérisé en ce**
**que** la première et la deuxième couche réfléchissante (11, 12) sont réalisées, vues de manière perpendiculaire par rapport au plan de la couche de structure (1a, 1a'), majoritairement ou totalement de manière à coïncider.

5. Elément de sécurité selon les revendications 1 à 4,
**caractérisé en ce**
**que** la première et la deuxième couche réfléchissante (11, 12) se distinguent en matière de matériau et/ou de couleur.

6. Elément de sécurité selon l'une quelconque des revendications 1 à 5,
**caractérisé en ce**
**que** la couche de structure (1a, 1a') présente une épaisseur de couche située dans la plage de 0,2 à 15 $\mu$m, en particulier dans la plage de 0,3 à 3 $\mu$m.

7. Elément de sécurité selon l'une quelconque des revendications 1 à 6,
**caractérisé en ce**
**que** l'élément de sécurité présente, vu par transparence, dans la zone au moins d'une des couches réfléchissantes (11, 12), des zones transmissives à perception différente, qui montrent une autre information.

8. Document de sécurité comprenant au moins un élément de sécurité (1, 1', 1") selon l'une quelconque des revendications 1 à 7,
**caractérisé en ce**
**que** l'au moins un élément de sécurité (1, 1', 1") est disposé, dans au moins une zone transparente du document de sécurité (500, 500') ou de manière à chevaucher en partie cette dernière.

9. Procédé servant à fabriquer un élément de sécurité (1) selon l'une quelconque des revendications 1 à 7, **caractérisé par** des étapes qui suivent consistant à :

a) fournir une première couche de réplication (1b) transparente ;
b) former une structure en relief principale (10) diffractive sur une première surface de la première couche de réplication (1b) ;
c) former la première couche de réplication (11) réalisée par endroits, éventuellement par ailleurs au moins une première couche auxiliaire opaque réalisée par endroits, sur la première surface ;
d) former la couche de structure (1a) au moins par endroits transparente par une deuxième couche de réplication, laquelle est disposée sur la première couche de réplication (11), et éventuellement sur l'au moins une première couche auxiliaire opaque et sur des zones libres de la première surface de cette dernière ;
e) former la deuxième structure en relief (10b) diffractive sur un second côté de la couche de structure (1a) ; et
f) former la deuxième couche réfléchissante (12) réalisée par endroits sur le second côté de la couche de structure (1a) en une épaisseur de couche, pour laquelle la deuxième structure de relief (10b) est moulée sur le côté, opposé à la couche de structure (1a), de la deuxième couche réfléchissante (12), dans lequel la distance moyenne entre la première et la deuxième couche réfléchissante est inférieure à 15 $\mu$m.

10. Procédé selon la revendication 9,
**caractérisé en ce**
**que** la première et/ou la deuxième couche réfléchissante sont réalisées de manière transparente et, vue de manière perpendiculaire par rapport au plan de la couche de structure, au moins une couche auxiliaire opaque est disposée de manière à coïncider avec la/les couche(s) réfléchissante(s) transparente(s).

11. Procédé servant à fabriquer un élément de sécurité (1') selon l'une quelconque des revendications 1 à 7, **caractérisé**

**par** des étapes qui suivent consistant à :

g) fournir une couche de structure (1a, 1a') transparente ;

h) former la première structure de relief (10a) diffractive sur un premier côté et la deuxième structure de relief (10b) diffractive sur un second côté de la couche de structure (1a, 1a') ;

i) former la première couche réfléchissante (11) réalisée au moins par endroits et éventuellement au moins une première couche auxiliaire opaque sur le premier côté de la couche de structure (1a, 1a') ; et

k) former la deuxième couche réfléchissante (12) réalisée au moins par endroits et éventuellement au moins une deuxième couche auxiliaire opaque sur le second côté de la couche de structure (1a, 1a'), dans lequel la distance moyenne entre la première et la deuxième couche réfléchissante est inférieure à 15 $\mu$m.

12. Procédé selon la revendication 9, 10 ou 11,
**caractérisé en ce**
**que** l'au moins une couche auxiliaire opaque est formée, la couche de structure étant exposée par endroits, et un agent colorant transparent contenu dans la couche de structure est transformé, dans les zones exposées, en un agent colorant opaque, coloré.

13. Procédé selon la revendication 11,
**caractérisé en ce**
**que** la première et la deuxième structure en relief (10a, 10b) sont formées de manière simultanée par estampage.

14. Procédé selon l'une quelconque des revendications 9 à 13,
**caractérisé en ce**
**qu'**à l'étape c) ou à l'étape i), la première couche réfléchissante (11) est appliquée sur toute la surface, en ce qu'une première couche photorésistante est appliquée sur toute la surface sur la première couche réfléchissante (11), en ce que la première couche photorésistante est exposée en partie et est retirée, dans lequel en particulier l'exposition de la première couche photorésistante a lieu au travers de la première couche réfléchissante (11), dans lequel l'exposition partielle de la première couche photorésistante est effectuée en fonction de la configuration et/ou de la disposition de la première structure en relief (10a), en ce que la première couche réfléchissante (11) est retirée par décapage dans les zones, dans lesquelles la première couche photorésistante a été retirée, et en ce qu'éventuellement les zones restantes de la première couche photorésistante sont retirées ou sont utilisées en tant qu'une première couche auxiliaire opaque.

15. Procédé selon l'une quelconque des revendications 9 à 14,
**caractérisé en ce**
**qu'**à l'étape f) ou à l'étape k), la deuxième couche réfléchissante (12) est appliquée sur toute la surface, en ce qu'une deuxième couche photorésistante est appliquée sur toute la surface sur la deuxième couche réfléchissante (12), en ce que la deuxième couche photorésistante est exposée en partie et est retirée, dans lequel en particulier l'exposition de la première couche photorésistante a lieu au travers de la première et de la deuxième couche réfléchissante (11, 12), dans lequel l'exposition partielle de la première couche photorésistante est effectuée en fonction de la configuration et/ou de la disposition de la première structure en relief (10a), en ce que la deuxième couche réfléchissante (12) est retirée par décapage dans les zones, dans lesquelles la deuxième couche photorésistante a été retirée, et en ce qu'éventuellement les zones restantes de la deuxième couche photorésistante sont retirées.

Fig. 1a

Fig. 1b

Fig. 2a

Fig. 2b

Fig. 2c

40

41

16

1a

10a

11

Fig. 2d

40

41

16

1a

12

10b

11

Fig. 2e

11

40

41

16

1a

12

30

Fig. 2f

40

41

16

1a

12

30

11

*Fig. 2g*

40

41

16

1a

30

11

12

*Fig. 2h*

1006

40

41

16

1a

20

11

200

1

12

100 a, 100 c

*Fig. 2i*

Fig. 3a

Fig. 3b

40

41

16

10

Fig. 4a

40

41

16

11

Fig. 4b

11

40

41

16

30

Fig. 4c

Fig. 4d

Fig. 4e

11

40

41

16

30

1a

12

Fig. 4f

200'

11

40

41

16

1a

30    1"

20

12

Fig. 4g

Fig. 5a

Fig. 5b

Fig. 5c

Fig. 5d

Fig. 6a

EP 2 117 840 B1

503

500'

505

1

501'

504

EP 2 117 840 B1

Fig. 6b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 102005017169 A1
- WO 9719820 A1
- DE 10226114 A1
- DE 102004042136 A1
- WO 2006084685 A2